# EUROPEAN PATENT APPLICATION

(11) **EP 4 571 334 A1**
(43) Date of publication of application: **18.06.2025**
(21) Application number: 23892760.2
(22) Date of filing: 29.11.2023
(51) Int. Cl.: G01R 31/36

(54) **TEST METHOD AND TEST SYSTEM**

(30) Priority: 10.10.2023 CN 202311302677
(71) Applicant: Contemporary Amperex Technology (Hong Kong) Limited, Central, Central And Western District (HK)
(72) Inventor: QIU, Shiping, Ningde, Fujian 352100 (CN)
(74) Representative: Ran, Handong
(86) International application number: PCT/CN2023/135170
(87) International publication number: WO 2025/076947

(57) **Abstract**

The present disclosure provides a testing method and a testing system. The testing method is applied to the testing system, and the testing system includes: at least one testing workstation and transportation equipment. Teach testing workstation includes: at least one testing instrument, at least one industrial personal computer, and at least two testing stations corresponding to each industrial personal computer. The testing method includes: transporting to-be-tested devices to at least two testing stations corresponding to any of the industrial personal computers in any testing workstation through the transportation equipment; and controlling, in a case that any of the industrial personal computers and the at least one testing instrument are in a connected state and the at least one testing instrument and the at least two testing stations are in a connected state, the to-be-tested devices on the at least two testing stations to perform corresponding performance testing through any of the industrial personal computers, wherein the at least two testing stations are independent of each other.

## Description

### Cross-Reference to Related Application

The present disclosure is proposed based on the China patent application No. 202311302677.6 filed on October 10, 2023 and entitled "Testing Method and Testing System", and claims priority of the Chinese Patent Application, the entire content of which is incorporated herein by reference.

### Technical Field

The present disclosure relates to the technical field of batteries, and relates to but is not limited to a testing method and a testing system.

### Background

New energy batteries are increasingly applied in life and industry. For example, new energy vehicles equipped with the batteries have been widely used. In addition, the batteries are further increasingly applied in the field of energy storage.

With the development of electric vehicles, the quantity demanded for battery packs is increasing year by year. In a product production process of a battery production line, it is necessary to perform electrical performance testing on the battery packs. For example, the electrical performance testing may include: air tightness performance testing, product end of line (EOL) performance testing and direct current resistance (DCR) performance testing, etc.

In the related art, when the electrical performance testing is performed on the battery packs, performance testing is usually performed on the battery packs on the production line in a one-by-one detection mode, which results in a long testing time for the electrical performance testing of the battery packs. Testing resources are limited, and an electrical performance testing procedure has become a production capacity bottleneck procedure, seriously affecting production capacity.

### Summary of the Invention

Embodiments of the present disclosure provide a testing method and a testing system, which can improve testing efficiency, thereby improving a production takt of a production line, and further increasing production capacity.

The technical solution of the present disclosure is implemented as follows.

In a first aspect, an embodiment of the present disclosure provides a testing method, applied to a testing system, the testing system including: at least one testing workstation and transportation equipment, wherein each testing workstation includes: at least one testing instrument, at least one industrial personal computer, and at least two testing stations respectively corresponding to each industrial personal computer, and the testing method includes:
transporting to-be-tested devices to the at least two testing stations corresponding to any of the industrial personal computers in any testing workstation through the transportation equipment; and
controlling, in a case that any of the industrial personal computers and the at least one testing instrument are in a connected state and the at least one testing instrument and the at least two testing stations are in a connected state, to-be-tested devices on the at least two testing stations to perform corresponding performance testing through any of the industrial personal computers, wherein the at least two testing stations are independent of each other.

According to the above technical means, on the one hand, the to-be-tested devices on the at least two testing stations are simultaneously controlled by any of the industrial personal computers to perform performance testing, which can make full use of equipment resources, reduce a testing time, and improve throughput of a production line. On the other hand, any of the industrial personal computers simultaneously controls the at least two testing stations, which can realize distributed testing, better balance a workload of different testing stations on the production line, ensure stability and production efficiency of the entire production line, thereby improving a production takt in a production process.

In the above solution, controlling the to-be-tested devices on the at least two testing stations to perform corresponding performance testing through any of the industrial personal computers includes: determining an overall testing procedure for performance testing corresponding to the to-be-tested devices on the at least two testing stations through any of the industrial personal computers, wherein the overall testing procedures for performance testing corresponding to the at least two testing stations are different; and controlling the to-be-tested devices on the at least two testing stations to perform the corresponding performance testing according to the overall testing procedures respectively corresponding to the at least two testing stations.

According to the above technical means, the to-be-tested devices on the at least two testing stations are simultaneously controlled to perform performance testing through any of the industrial personal computers, and the overall testing procedures corresponding to the at least two testing stations may be different. In this way, different testing tasks are performed according to different to-be-tested devices and testing requirements, which can help to improve production efficiency and diversity while ensuring testing accuracy and consistency.

In the above solution, determining the overall testing procedure for performance testing corresponding to the to-be-tested devices on the at least two testing stations through any of the industrial personal computers includes: acquiring product information of the to-be-tested devices on the at least two testing stations through any of the industrial personal computers; and determining the overall testing procedure of the to-be-tested devices on the at least two testing stations according to the product information of the to-be-tested devices on the at least two testing stations.

According to the above technical means, any of the industrial personal computers determines the respective overall testing procedures according to the product information of the to-be-tested devices, so as to be capable of performing customized and personalized testing procedures for the to-be-tested device located on each testing station, ensuring that testing may meet specific specifications and requirements, avoiding unnecessary testing steps, reducing unnecessary testing time and resource waste, thereby improving resource utilization and production efficiency.

In the above solution, the product information varies among the to-be-tested devices on the at least two testing stations; and the product information includes at least one of the following: model information, project information or blueprint information of the to-be-tested devices.

According to the above technical means, on the one hand, the product information of the to-be-tested devices on the at least two testing stations corresponding to any of the industrial personal computers is different. In this way, any of the industrial personal computers may determine the corresponding overall testing procedure according to different product information, and may perform corresponding performance testing for specific specifications and requirements, thereby improving production and testing efficiency. On the other hand, the corresponding overall testing process may be customized according to the production information of the different to-be-tested devices, so that resource utilization can be increased.

In the above solution, an identification label is affixed to the to-be-tested devices; and each testing workstation further includes: recognition equipment, configured to recognize the identification label on the to-be-tested device; and
acquiring the product information of the to-be-tested devices on the at least two testing stations through any of the industrial personal computers includes:
reading, in a case that the to-be-tested device arrives at any of the at least two testing stations, the identification label of the to-be-tested device on any testing station through the recognition equipment corresponding to any testing station; and
parsing the identification label of the to-be-tested device through the recognition equipment so as to acquire the product information of the to-be-tested device, and transmitting the product information of the to-be-tested devices to any of the industrial personal computers corresponding to any testing station, such that any of the industrial personal computers acquires the product information of the to-be-tested devices on the at least two testing stations.

According to the above technical means, on the one hand, through the automatic reading of the identification label, information transmission and data management of the industrial personal computer, more efficient, more accurate and more controllable production line operations may be achieved. On the other hand, one industrial personal computer may acquire the product information between the at least two testing stations, so as to achieve a higher degree of collaborative work and resource sharing, thereby improving the product quality and production efficiency, and reducing errors and costs.

In the above solution, each testing workstation further includes: verification equipment, configured to verify the product information of the to-be-tested devices, and the testing method further includes:
transmitting the product information of the to-be-tested devices on the at least two testing stations to the verification equipment through any of the industrial personal computers; and
verifying the product information of the to-be-tested devices on the at least two testing stations through the verification equipment so as to obtain verification results, wherein the verification results are used for indicating whether the product information of the to-be-tested devices is compliant.

According to the above technical means, the product information of the to-be-tested devices on at least two testing stations is verified by the verification equipment, which can ensure that the product information of the to-be-tested devices is accurate, improve the controllability, quality and efficiency of a manufacturing process, and reduce production risks and costs, thereby reducing the risk of producing unaccepted product and improving the quality of produced products.

In the above solution, after verifying the product information of the to-be-tested devices on the at least two testing stations through the verification equipment so as to obtain the verification results, the testing method further includes:
feeding, by the verification equipment, the verification results of the to-be-tested devices on the at least two testing stations back to any corresponding industrial personal computer; and
executing, in a case that the verification results indicate that the product information of the to-be-tested devices on the at least two testing stations is compliant, a step of controlling the to-be-tested devices on the at least two testing stations to perform corresponding performance testing through any of the industrial personal computers.

According to the above technical means, by feeding back the verification results of the to-be-tested devices to the industrial personal computer and deciding whether to perform the corresponding performance testing on the to-be-tested devices according to the verification results, real-time monitoring and management of the production quality can be achieved, and measures can be taken timely to ensure product compliance, thereby helping improve the controllability and traceability of the production line, and ensuring the product quality while reducing the production risks and costs.

In the above solution, the at least two testing stations controlled by any of the industrial personal computers are respectively deployed on at least two transmission channels, and the at least two transmission channels are independent of each other; and
controlling the to-be-tested devices on the at least two testing stations to perform corresponding performance testing according to the overall testing procedures respectively corresponding to the at least two testing stations includes:
controlling, through any of the industrial personal computers, the to-be-tested device located on each testing station of the at least two transmission channels to simultaneously perform the performance testing of the respectively corresponding overall testing procedures; or
controlling, through any of the industrial personal computers, the to-be-tested device located on each testing station of any transmission channel to sequentially perform the performance testing of the respectively corresponding target testing procedures, wherein
the target testing procedure belongs to a partial testing procedure in the overall testing procedure; and the overall testing procedure corresponding to any transmission channel is a sum of the target testing procedures corresponding to the individual testing stations on any transmission channel.

According to the above technical means, on the one hand, any of the industrial personal computers can simultaneously control the performance testing of the plurality of testing stations, reduce a waiting time of the testing procedure and improve the overall efficiency of the production line. On the other hand, the individual testing stations on any transmission channel can sequentially perform testing, thereby shortening the time of the entire testing process and improving the overall efficiency of the production line.

In the above solution, controlling, through any of the industrial personal computers, the to-be-tested device located on each testing station of any transmission channel to sequentially perform performance testing of the respectively corresponding target testing procedures includes:
splitting, through any of the industrial personal computers, the overall testing procedure corresponding to any transmission channel according to the station number of the testing stations located on any transmission channel, so as to determine the target testing procedure of the testing station on any transmission channel corresponding to any of the industrial personal computers; and
controlling, through any of the industrial personal computers, the to-be-tested device on the testing station on any transmission channel corresponding to any of the industrial personal computers to perform performance testing of the target testing procedure corresponding to the testing station, wherein
a difference between testing times of the target testing procedures at the individual testing stations for the to-be-tested device located on any transmission channel is less than or equal to a preset threshold.

According to the above technical means, on the one hand, by splitting the overall testing procedure according to the number of the testing stations on any transmission channel, performance testing of the plurality of testing stations can be performed in parallel, thereby greatly improving the testing efficiency and reducing testing time. On the other hand, any testing station on any transmission channel does not need to wait for other testing stations to complete the testing, thereby reducing an idle time of the testing equipment and increasing resource utilization.

In the above solution, any testing workstation is a first testing workstation, configured to perform product end-of-line performance testing on the to-be-tested devices; the at least two transmission channels includes: a first transmission channel and a second transmission channel; any of the industrial personal computers is a first industrial personal computer; and the at least two testing stations corresponding to the first industrial personal computer includes: a first testing station located on the first transmission channel and a second testing station located on the second transmission channel; and controlling, through any of the industrial personal computers, the to-be-tested device on the testing station on any transmission channel corresponding to any of the industrial personal computers to perform performance testing of the target testing procedure corresponding to the testing station includes:
transporting first to-be-tested device to the first testing station through the transportation equipment; and
controlling, through the first industrial personal computer in a case that the first industrial personal computer perceives that the first to-be-tested device arrives at the first testing station, the first to-be-tested device to perform product end-of-line performance testing of a first target testing procedure corresponding to the first testing station; and/or,
transporting second to-be-tested device to the second testing station through the transportation equipment; and
controlling, through the first industrial personal computer in a case that the first industrial personal computer perceives that the second to-be-tested device arrives at the second testing station, the second to-be-tested device to perform product end-of-line performance testing of a second target testing procedure corresponding to the second testing station, wherein
the first target testing procedure is a partial testing procedure in a first overall testing procedure corresponding to the first transmission channel, and the second target testing procedure is a partial testing procedure in a second overall testing procedure corresponding to the second transmission channel; and first overall testing procedure is related to product information of the first to-be-tested device, and the second overall testing procedure is related to product information of the second to-be-tested device.

According to the above technical means, on the one hand, the performance testing is simultaneously performed on the to-be-tested devices on the two different transmission channels, which reduces the waiting time of the testing procedure and thus speeds up the production. On the other hand, customized performance testing can be performed on different types of to-be-tested devices based on the product information on the different transmission channels and the different overall testing procedures, which improves the flexibility and adaptability of the production line. In addition, since the testing procedures are performed in parallel, the number of the testing equipment and the industrial personal computers can be reduced, thereby reducing equipment and labor costs. On the other hand, by processing different testing procedures in parallel, the idle time on the production line is reduced, and the production process is made more continuous.

In the above solution, the first testing workstation further includes: a second industrial personal computer; and the testing method further includes:
controlling, through the second industrial personal computer after the first to-be-tested device and/or the second to-be-tested device completes the product end-of-line performance testing of the target testing procedure corresponding to the first industrial personal computer, the first to-be-tested device and/or the second to-be-tested device to perform product end-of-line performance testing of a testing procedure other than the target testing procedure corresponding to the first industrial personal computer.

According to the above technical means, by controlling, through the second industrial personal computer, the first to-be-tested device and/or the second to-be-tested device to perform the product end-of-line performance testing of the testing procedure other than the target testing procedure corresponding to the first industrial personal computer, different industrial personal computers may be made in parallel to control different testing procedures for the product end-of-line performance testing, thereby greatly improving the testing efficiency and reducing the testing time.

In the above solution, the at least two testing stations corresponding to the second industrial personal computer include: a third testing station located on the first transmission channel and a fourth testing station located on the second transmission channel, the third testing station is deployed following the first testing station, and the fourth testing station is deployed following the second testing station; and controlling, through the second industrial personal computer, the first to-be-tested device and/or the second to-be-tested device to perform product end-of-line performance testing of the testing procedure other than the target testing procedure corresponding to the first industrial personal computer includes:
controlling, through the second industrial personal computer in a case that the second industrial personal computer perceives that the first to-be-tested device arrives at the third testing station, the first to-be-tested device to perform product end-of-line performance testing of a third target testing procedure corresponding to the third testing station; and/or,
controlling, through the second industrial personal computer in a case that the second industrial personal computer perceives that the second to-be-tested device arrives at the fourth testing station, the second to-be-tested device to perform product end-of-line performance testing of a fourth target testing procedure corresponding to the fourth testing station, wherein
a sum of the first target testing procedure and the third target testing procedure is the first overall testing procedure; and a sum of the second target testing procedure and the fourth target testing procedure is the second overall testing procedure.

According to the above technical means, on the one hand, the to-be-tested devices may be tested in parallel at different testing stations without waiting for one equipment to complete all testing, allowing the plurality of testing procedures to be performed simultaneously, thereby improving the efficiency of the production line. On the other hand, the production cost can be reduced by maximizing the use of existing equipment and resources. In addition, the unnecessary production line downtime cost caused by the waiting time and changeover time is saved. On the other hand, since any of the industrial personal computers can be configured to perform different testing procedures for the at least two testing stations, the production line can easily adapt to different models or blueprints of products without the need for large-scale production line reconstruction or changes.

In the above solution, the at least one testing workstation further includes: a second testing workstation, configured to perform direct current resistance performance testing on the to-be-tested devices; the second testing workstation is a testing workstation following the first testing workstation; the second testing workstation includes: a third industrial personal computer; and the testing method further includes:
after the first to-be-tested device and/or the second to-be-tested device complete(s) the product end-of-line performance testing of the first testing workstation, the first to-be-tested device and/or the second to-be-tested device are/is controlled through the third industrial personal computer to perform direct current resistance performance testing.

According to the above technical means, by controlling, through the third industrial personal computer, the first to-be-tested device and/or the second to-be-tested device to perform direct current resistance performance testing, different industrial personal computers may be made in parallel to control different testing procedures for the different types of performance testing, thereby greatly improving the testing efficiency and reducing the testing time.

In the above solution, the at least two testing stations corresponding to the third industrial personal computer include: a fifth testing station located on the first transmission channel and a sixth testing station located on the second transmission channel, the fifth testing station is deployed following the third testing station, and the sixth testing station is deployed following the fourth testing station; and controlling, through the third industrial personal computer, the first to-be-tested device and/or the second to-be-tested device to perform direct current resistance performance testing includes:
controlling, through the third industrial personal computer in a case that the third industrial personal computer perceives that the first to-be-tested device arrives at the fifth testing station, the first to-be-tested device to perform direct current resistance performance testing of a third overall testing procedure corresponding to the fifth testing station; and/or,
controlling, through the third industrial personal computer in a case that the third industrial personal computer perceives that the second to-be-tested device arrives at the sixth testing station, the second to-be-tested device to perform direct current resistance performance testing of a fourth overall testing procedure corresponding to the sixth testing station, wherein
the third overall testing procedure is related to product information of the first to-be-tested device, and the fourth overall testing procedure is related to product information of the second to-be-tested device.

According to the above technical means, on the one hand, by simultaneously executing the plurality of testing procedures, the entire testing cycle is reduced, and the testing efficiency of the production line can be improved. On the other hand, the production cost can be reduced by maximizing the use of the existing equipment and resources. In addition, the unnecessary production line downtime cost caused by the waiting time and changeover time is saved.

In the above solution, the at least one testing workstation further includes: a third testing workstation, configured to perform air tightness performance testing on the to-be-tested devices; and the third testing workstation is a testing workstation prior to the first testing workstation; and before controlling, through any of the industrial personal computers, the to-be-tested devices on the at least two testing stations to perform the product end-of-line performance testing, the testing method further includes:
controlling, through the industrial personal computer in the third testing workstation, the to-be-tested devices on the at least two testing stations to perform air tightness performance testing.

According to the above technical means, by processing the different testing procedures in parallel, the idle time on the production line is reduced, and the production process is made more continuous, thereby achieving non-stop changeover to increase the production line utilization.

In a second aspect, an embodiment of the present disclosure provides a testing system. The testing system includes: at least one testing workstation, configured to perform at least one performance testing on to-be-tested devices. Each testing workstation includes:
at least one testing instrument, at least one industrial personal computer, and at least two testing stations respectively corresponding to each industrial personal computer;
any of the industrial personal computers is connected with the at least one testing instrument;
the at least one testing instrument is connected with the at least two testing stations; and
any of the industrial personal computers is configured to control the to-be-tested devices on the at least two testing stations to perform corresponding performance testing based on the at least one testing instrument, wherein the at least two testing stations are independent of each other.

### Description of Drawings

Accompanying drawings here are incorporated in and constitute a part of this specification, and these accompanying drawings illustrate embodiments consistent with the present disclosure and together with the specification, serve to explain the technical solutions of the present disclosure. Apparently, the accompanying drawings described below are merely some embodiments of the present disclosure. For those of ordinary skills in the art, other accompanying drawings may further be obtained according to these accompanying drawings without making creative work.

The flowcharts shown in the accompanying drawings are only exemplary illustration, and do not necessarily include all contents and operations/steps, nor does it have to be executed in the order described. For example, some operations/steps can further be decomposed, and some operations/steps can be merged or partially merged, so the actual order of execution may change according to the actual situation.
Fig. 1 is a first schematic flow diagram of an optional testing method provided by an embodiment of the present disclosure.
Fig. 2 is a second schematic flow diagram of an optional testing method provided by an embodiment of the present disclosure.
Fig. 3 is a third schematic flow diagram of an optional testing method provided by an embodiment of the present disclosure.
Fig. 4 is a fourth schematic flow diagram of an optional testing method provided by an embodiment of the present disclosure.
Fig. 5 is a fifth schematic flow diagram of an optional testing method provided by an embodiment of the present disclosure.
Fig. 6 is a top view of an optional testing system provided by an embodiment of the present disclosure.
Fig. 7 is a front view of an optional testing system provided by an embodiment of the present disclosure.
Fig. 8 is a left view of an optional testing system provided by an embodiment of the present disclosure.
Fig. 9 is a stereogram of an optional testing system provided by an embodiment of the present disclosure.
Fig. 10 is a schematic connection diagram of a testing instrument of an optional first testing workstation provided by an embodiment of the present disclosure.
Fig. 11 is a schematic connection diagram of a testing instrument of an optional second testing workstation provided by an embodiment of the present disclosure.
Fig. 12 is a schematic structural diagram of an optional first bracket provided by an embodiment of the present disclosure.
Fig. 13 is a schematic structural diagram of an optional second bracket provided by an embodiment of the present disclosure.

In the accompanying drawings, the accompanying drawings are not drawn to actual scale.

Reference numerals in Detailed Description are as follows:
11-First testing workstation; 12-Second testing workstation;
21-First instrument cabinet; 211-Withstand voltage tester; 212-Equipotential tester; 213-Multimeter; 214-Communication module; 215-First power supply; 216-Relay;
22-Second instrument cabinet; 221-Charging and discharging equipment;
2141-First communication submodule; 2142-Second communication submodule;
3-Industrial personal computer; 31-First industrial personal computer 32-Second industrial personal computer; 33-Third industrial personal computer;
41-First testing station; 42-Second testing station; 43-Third testing station; 44-Fourth testing station; 45-Fifth testing station; 46-Sixth testing station;
5-Material cabinet;
61-First bracket; 611-Adapter box;
62-Second bracket; 621-High-voltage adapter box; 622-Second power supply;
7-To-be-tested devices; 8-Display equipment; 9-Verification equipment.

### Detailed Description

In order to make objectives, technical solutions and advantages of embodiments of the present disclosure clearer, the specific technical solutions of the present disclosure will be described below in detail with reference to accompanying drawings in the embodiments of the present disclosure. The following embodiments serve to illustrate the present disclosure but are not intended to limit the scope of the present disclosure.

Unless otherwise defined, all technical and scientific terms used herein have the same meaning as commonly understood by those skilled in the art belonging to the technical field of the present disclosure. The terms used herein are intended only for the purpose of describing this embodiment and are not intended to limit the present disclosure.

In the following description, "some embodiments", "this embodiment", "this embodiment", examples and the like are involved, which describe a subset of all possible embodiments, but it may be understood that "some embodiments" may be the same subset or different subsets of all the possible embodiments, and may be combined with each other without conflict.

If a similar description of "first/second" appears in the public document, the following description is added, in which the term "first/second/third" involved merely distinguishes similar objects, and does not represent a specific ordering for the objects. It may be understandable that "first/second/third" may interchange specific orderings or sequences, if permitted, so that this embodiment described herein can be implemented in an order other than that illustrated or described herein.

In this embodiment, the term "and/or" is only an association relation describing associated objects, which means that there may be three relations. For example, an object A and/or an object B may represent three situations: the object A exists alone, both the object A and the object B exist, and the object B exists alone.

At present, new energy batteries are increasingly applied in daily life and industry. The new energy batteries are not only applied in energy storage power supply systems such as water power, fire power, wind power, and solar power stations, but also widely applied in electric transportation tools, such as electric bicycles, electric motorcycles and electric vehicles, as well as many fields, such as aerospace. With the continuous expansion of the application field of the power batteries, the market demand is also constantly expanding.

In an embodiment of the present disclosure, a battery may be a battery cell. The battery cell refers to a basic unit that can realize mutual conversion of chemical energy and electrical energy, and may be used to make a battery module or a battery pack to provide power to an electrical apparatus. The battery cell may be a secondary battery, and the secondary battery refers to a battery cell that can be used continually by activating a active material in a charging manner after the battery cell is discharged. The battery cell may be a lithium-ion battery, a sodium ion battery, a sodium-lithium ion battery, a lithium metal battery, a sodium metal battery, a lithium sulfur battery, a magnesium-ion battery, a nickel hydrogen battery, a nickel cadmium battery, a lead accumulator, etc., which is not limited in the embodiment of the present disclosure.

In the related art, in a product production process of production equipment at any procedure of a battery production line, when electrical performance testing is performed on battery packs, performance testing is usually performed on the battery packs on the production line in sequence in a one-by-one detection mode, which may lead to the following technical problems:
1) only one product can be produced simultaneously, and testing can only be done one by one, making it impossible to test a plurality of products simultaneously, resulting in low testing efficiency.
   An existing production line and testing equipment are often designed for specific products or models and do not have the flexibility to adapt to testing the plurality of products simultaneously. Upgrading or replacing testing equipment may require greater investment and engineering modifications. Due to design limitations of the existing production line and testing equipment, the relevant testing equipment may only support the testing of one product and cannot handle the plurality of products simultaneously.
2) When the production line needs to be switched and changed, the changeover time is long and the changeover cost is high.
   The existing testing equipment usually does not have functions of quick switching and configuration. The adjustment, calibration, configuration of the testing equipment, and changes in related documents and procedures usually lead to the long changeover time. The related changeover procedures may not be optimized enough and require manual intervention and adjustment, resulting in increased time costs.
3) The production line occupies a large area, the testing efficiency is low, and the cost of testing equipment is high.

The existing production line and testing equipment require a lot of space, the testing process is not compact enough, and the equipment efficiency is low, resulting in the production line occupying a large area. In addition, the existing production line and testing equipment lack automation and optimization measures, which in turn affects the utilization and testing efficiency of the testing equipment.

Based on the above technical problems, an embodiment of the present disclosure provides a testing method, so as to improve testing efficiency, thereby improving a production takt of a production line, and further increasing production capacity. The technical solution of the present disclosure will be described in detail below with reference to the accompanying drawings.

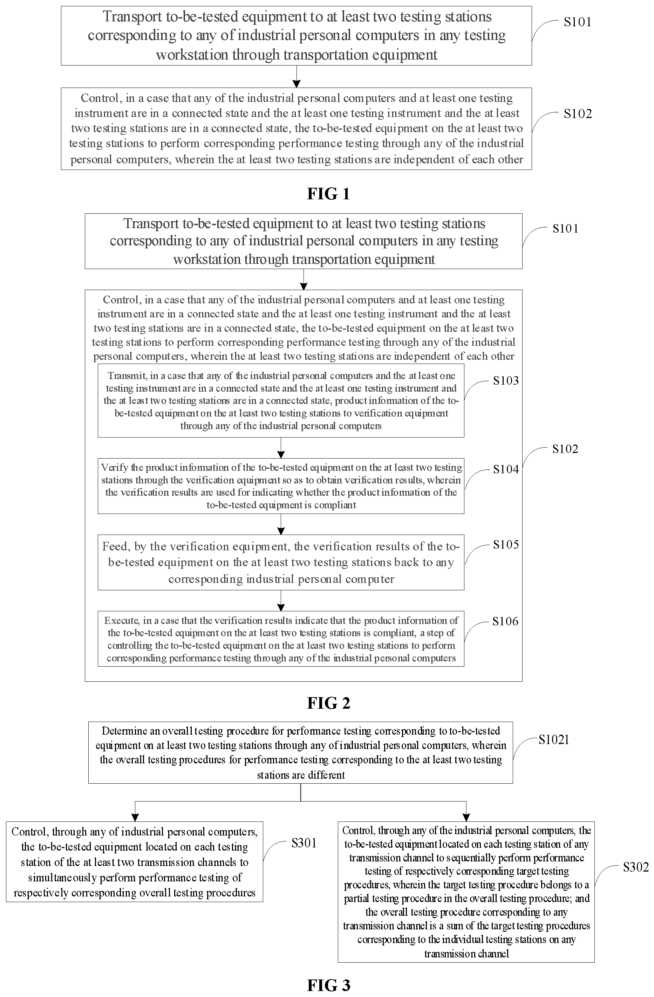

Referring to Fig. 1, Fig. 1 is a first schematic flow diagram of an optional testing method provided by an embodiment of the present disclosure. The testing method is applied to a testing system, and the testing system includes: at least one testing workstation and transportation equipment, wherein each testing workstation includes: at least one testing instrument, at least one industrial personal computer, and at least two testing stations respectively corresponding to each industrial personal computer, and the testing method includes S101 to S102.

S101, to-be-tested devices are transported to the at least two testing stations corresponding to any of the industrial personal computers in any testing workstation through the transportation equipment.

In the embodiment of the present disclosure, the to-be-tested devices may be a battery pack. The battery pack is an apparatus composed of a plurality of battery cells, and aimed to store electrical energy and provide electric power supplying. The components of the battery pack include at least: the battery cells, a battery management system (BMS), a housing, a connection harness, a connector, an interface, etc. These components work together to combine the battery cells into a fully functional battery pack for a variety of application scenarios. For example, the battery pack may be applied to an electric vehicle, an energy storage system, portable electronic equipment, a solar system, a wind energy system, an emergency backup power supply, an electric tool, or an electric bicycle, etc, and the present disclosure does not impose any limitations on this.

It should be noted that the battery pack may use different types of battery cells, such as a lithium-ion battery, a nickel-hydrogen battery and a lithium-polymer battery, which is determined according to the actual application needs and performance requirements, and the present disclosure does not impose any limitations on this.

In the embodiment of the present disclosure, the testing station may be called a testing station of the battery pack. Each testing station is configured to perform at least one performance testing on the to-be-tested devices. Each testing station may be equipped with a plurality of testing sensors to collect and analyze performance data of the to-be-tested devices.

In the embodiment of the present disclosure, the transportation equipment is configured to transport the to-be-tested devices to any of the at least two testing stations corresponding to any of the industrial personal computers in any testing workstation through the transportation equipment.

In the embodiment of the present disclosure, the transportation equipment transports the to-be-tested devices to any of the at least two testing stations corresponding to any of the industrial personal computers in any testing workstation in response to a received transportation instruction. The transportation instruction is used to indicate positioning information or guidance information of any testing station corresponding to the to-be-tested devices.

In the embodiment of the present disclosure, the transportation equipment may be an automated guided vehicle (AGV), a mechanical arm, and a conveyor belt.

Exemplarily, the to-be-tested devices are placed on a pallet on AGV equipment. In a case that the AGV equipment perceives that the to-be-tested devices are in place through its own sensor, the AGV equipment transports the to-be-tested devices to the designated testing station according to a predetermined route.

In the embodiment of the present disclosure, the number of the transportation equipment may be one or at least two, and the present disclosure does not impose any limitations on this.

In the embodiment of the present disclosure, the number of the transportation equipment is related to the number of transmission channels of the at least one testing workstation and/or the number of the testing stations in any testing workstation.

In the embodiment of the present disclosure, the number of the transportation equipment may be greater than or equal to the number of the transmission channels; or, the number of the transportation equipment may be less than the number of the testing stations in any testing workstation.

Exemplarily, in a case that the number of the transportation equipment is equal to the number of the transmission channels, each transportation equipment corresponds to one transmission channel, and each transportation equipment is configured to transport the to-be-tested devices to any testing station in the same transmission channel. In a case that the number of the transportation equipment is equal to the number of the testing stations in any testing workstation, each transportation equipment corresponds to one testing station, and each transportation equipment is configured to transport the to-be-tested devices to the corresponding testing station.

It may be understood that, on the one hand, transporting the to-be-tested devices to the corresponding testing station through the transportation equipment can reduce manual carrying, improve production efficiency and reduce human transportation errors, thereby improving transportation safety and effectively reducing the operating costs of the production line. On the other hand, the transportation equipment may perform corresponding transportation operations according to the received transportation instructions, and its paths and transportation tasks may be flexibly adjusted according to needs. Therefore, it can better adapt to changes in the production line and the transportation needs, and can be applied to transportation scenarios of various production lines. In short, the transportation efficiency and accuracy may be improved through automated transportation equipment, which can reduce the risks of manual operations while increasing productivity.

S102, in a case that any of the industrial personal computers and the at least one testing instrument are in a connected state and the at least one testing instrument and the at least two testing stations are in a connected state, the to-be-tested devices on the at least two testing stations are controlled to perform corresponding performance testing through any of the industrial personal computers, wherein the at least two testing stations are independent of each other.

In the embodiment of the present disclosure, before controlling the to-be-tested devices on the at least two testing stations to perform corresponding performance testing, it is necessary to ensure that a physical connection among any of the industrial personal computers, the at least one testing instrument, and the at least two testing stations is correctly established, specifically including: correct data line, communication protocol and interface settings.

In the embodiment of the present disclosure, appropriate industrial control software needs to be installed and configured on any of the industrial personal computers to facilitate communication and control of the at least one testing instrument and the at least two testing stations. In this process, an appropriate control interface and related testing procedures need to be set. In addition, the industrial control software needs to be written or configured on any of the industrial personal computers to control the at least one testing instrument. This process can be achieved through a communication protocol. Exemplarily, a general purpose interface bus (GPIB), a universal serial bus (USB), a local area network (LAN), etc. may be used to achieve communication. In this way, the communication between any of the industrial personal computers and the at least one testing instrument may be established. Any industrial personal computer may send a control instruction to the at least one testing instrument. In response to the received control instruction, the at least one testing instrument tests the to-be-tested devices to obtain the corresponding testing result, and feeds the testing result back to any of the industrial personal computers. In this way, any of the industrial personal computers may receive the testing result sent by the at least one testing instrument.

In the embodiment of the present disclosure, any of the industrial personal computers can independently control the at least two testing stations, which can be realized through a multi-thread or parallel processing function of the industrial control software. In this way, it may be ensured that any of the industrial personal computers can simultaneously test the to-be-tested devices on the at least two testing stations.

It may be understood that in a process of controlling the to-be-tested devices on the at least two testing stations through any of the industrial personal computers to perform corresponding performance testing, an automatic testing process is realized through a script or program in any of the industrial personal computers. In this way, performance testing of batches of to-be-tested devices can be achieved, thereby reducing operator intervention.

It may be understood that by controlling the to-be-tested devices on the at least two independent testing stations through any of the industrial personal computers to perform corresponding performance testing, production efficiency and testing consistency can be improved, which is suitable for large-scale manufacturing and testing processes, and can increase the production capacity.

In the embodiment of the present disclosure, the to-be-tested device on any of the at least two testing stations needs to be connected with the corresponding testing station and equipped with a corresponding testing interface. In this way, any of the industrial personal computers may control the to-be-tested device on any testing station to perform the corresponding performance testing.

In the embodiment of the present disclosure, testing task allocation is configured in the industrial control software configured on any of the industrial personal computers to ensure that any of the industrial personal computers can allocate the appropriate testing tasks to different testing stations and testing instruments according to actual needs. In addition, any of the industrial personal computers further needs to collect and analyze data returned from the at least one testing instrument and testing station, and recording the corresponding testing results.

In the embodiment of the present disclosure, any of the industrial personal computers further has a safety function, so that in a case of a problem or malfunction during the production process, appropriate safety measures may be taken, so as to protect the safety of the equipment and operators of the testing system.

In the embodiment of the present disclosure, the testing method is provided. Firstly, the to-be-tested devices are transported to the at least two testing stations corresponding to any of the industrial personal computers in any testing workstation through the transportation equipment; and then in a case that any of the industrial personal computers and the at least one testing instrument are in the connected state and the at least one testing instrument and the at least two testing stations are in the connected state, the to-be-tested devices on the at least two testing stations are controlled to perform corresponding performance testing through any of the industrial personal computers. On the one hand, the to-be-tested devices on the at least two testing stations are simultaneously controlled by any of the industrial personal computers to perform performance testing, which can make full use of equipment resources, reduce a testing time, and improve throughput of a production line. On the other hand, any of the industrial personal computers simultaneously controls the at least two testing stations, which can realize distributed testing, better balance a workload of different testing stations on the production line, ensure stability and production efficiency of the entire production line, thereby improving a production takt in a production process.

It may be understood that in the embodiment of the present disclosure, on the one hand, the to-be-tested device is automatically transported to the corresponding testing station through the transportation equipment, which reduces operator access and physical movement between the testing workstations, thereby speeding up the testing process and improving the production efficiency. On the one hand, by simultaneously controlling the at least two testing stations through the same industrial personal computer, the same industrial personal computer can be used to test the to-be-tested devices, thereby ensuring the consistency of the testing method and testing standards, and helping to reduce testing differences and improve comparability of the testing results. On the one hand, automatic testing and automatic transportation are achieved throughout the entire testing process, thus reducing the risk of human errors and improving the accuracy and reliability of the testing results. On the other hand, since the plurality of testing stations can share one industrial personal computer, equipment and maintenance costs can be saved, and the idle time of the equipment is reduced. On the other hand, controlling the plurality of testing stations through any of the industrial personal computers makes it easier to integrate and record testing data, facilitate real-time monitoring and data analysis, and help improve controllability and quality management in the production process.

In general, through the embodiment of the present disclosure, it is helpful to optimize the production process, improve the production efficiency, reduce the human errors, save the resources, and achieve better data management and monitoring, thereby improving the overall performance and maintainability of the production line.

In some embodiments of the present disclosure, the implementation of controlling the to-be-tested devices on the at least two testing stations to perform corresponding performance testing through any of the industrial personal computers in S102 may include S1021 to S1022:
S1021, an overall testing procedure for performance testing corresponding to to-be-tested devices on at least two testing stations is determined through any of the industrial personal computers, wherein the overall testing procedures for performance testing corresponding to the at least two testing stations are different.

In the embodiment of the present disclosure, the overall testing procedure refers to a completed testing procedure of the to-be-tested devices in a performance testing process.

In the embodiment of the present disclosure, for any of the industrial personal computers, the overall testing procedures of the to-be-tested devices on the at least two testing stations controlled by it may be the same or different, and the embodiment of the present disclosure does not impose any limitations on this.

In the embodiment of the present disclosure, the overall testing procedure is related to product information of the to-be-tested devices. This is because the overall testing procedure is formulated according to the product information of the to-be-tested devices, such as product's characteristics, specifications and requirements. In other words, according to the different product information of the different to-be-tested devices, the corresponding overall testing procedures are different.

Exemplarily, the product information includes the design specifications and performance requirements of the equipment or product. The overall testing procedure needs to take into account that the product needs to work within these specified specifications. Therefore, design specification information in the product information needs to be considered when formulating the overall testing procedure. In addition, according to the characteristics of the product information of the to-be-tested devices, appropriate testing instruments or equipment need to be selected and configured. Different to-be-tested devices requires different testing instruments, testing parameters, and testing procedures when performing the performance testing. For example, the types and scopes of testing data that need to be collected may be different. Hence, the overall testing procedures of the to-be-tested devices with the different product information are different.

It may be understood that the overall testing procedures of different performance testing is executed on different testing stations, and the industrial personal computer is used to control and manage these testing processes. This helps ensure that performance testing on each testing station is performed according to its specific requirements and processes, and achieve flexibility and customization of testing. In this way, testing efficiency, quality control and production flexibility can be improved.

In some embodiments of the present disclosure, the implementation of determining the overall testing procedures of the performance testing corresponding to the to-be-tested devices on the at least two testing stations in S1021 may include S201 to S202:
S201, the product information of the to-be-tested devices on the at least two testing stations is acquired through any of the industrial personal computers.

In some embodiments of the present disclosure, the product information varies among the to-be-tested devices on the at least two testing stations; and the product information includes at least one of the following: model information, project information or blueprint information of the to-be-tested devices.

In the embodiment of the present disclosure, the at least two testing stations controlled by any of the industrial personal computers are independent of each other, therefore, the product information varies among the to-be-tested devices on the at least two testing stations.

In the embodiment of the present disclosure, the model information is used to distinguish different models of to-be-tested devices, and may include: a model name, model number, or model identification of the equipment. The project information is used to reflect data related to a production project of the to-be-tested devices, and may include: a project name, a project number, a project plan start date and end date, etc. The blueprint information is used to characterize information of product design specifications and design requirements of the to-be-tested devices, and may include: information related to design drawings, information related to specifications, information related to design change records, etc.

It may be understood that on the one hand, the product information of the to-be-tested devices on the at least two testing stations corresponding to any of the industrial personal computers is different. In this way, any of the industrial personal computers may determine the corresponding overall testing procedure according to different product information, and may perform corresponding performance testing for specific specifications and requirements, thereby improving production and testing efficiency. On the other hand, the corresponding overall testing procedure may be customized according to the production information of the different to-be-tested devices, so that resource utilization can be increased.

S202, the overall testing procedure of the to-be-tested devices on the at least two testing stations is determined according to the product information of the to-be-tested devices on the at least two testing stations.

In the embodiment of the present disclosure, after any of the industrial personal computers acquires the product information of the to-be-tested devices on the at least two testing stations, the industrial personal computer determines the overall testing procedure of the to-be-tested devices on the at least two testing stations according to the product information of the to-be-tested devices.

In the embodiment of the present disclosure, the overall testing procedures of the to-be-tested devices on the at least two testing stations corresponding to any of the industrial personal computers may be different.

Exemplarily, the at least two testing stations controlled by any of the industrial personal computers include: a testing station A and a testing station B. The product information of the to-be-tested devices a flowing into the testing station A is information X, and the product information of the to-be-tested devices b flowing into the testing station B is information Y. Since the information X and the information Y are different, the overall testing procedure corresponding to the to-be-tested devices a and the overall testing procedure corresponding to the to-be-tested devices b are different. In other words, different product information may result in different overall testing procedures for each to-be-tested devices. Any industrial personal computer may determine different overall testing procedures according to the different product information, helping to provide personalized testing procedure settings.

It may be understood that any of the industrial personal computers determines the respective overall testing procedures according to the product information of the to-be-tested devices, so as to be capable of performing customized and personalized testing procedures for the to-be-tested device located on each testing station, ensuring that testing may meet specific specifications and requirements, avoiding unnecessary testing steps, reducing unnecessary testing time and resource waste, thereby improving resource utilization and production efficiency.

S1022, the to-be-tested devices on the at least two testing stations is controlled to perform corresponding performance testing according to the overall testing procedures respectively corresponding to the at least two testing stations.

In the embodiment of the present disclosure, the overall testing procedure includes testing steps and parameter settings of performance testing. For the to-be-tested device on any testing station, the corresponding overall testing procedure is started through any of the industrial personal computers corresponding to any testing station, so as to select the appropriate testing type and testing parameters.

In the embodiment of the present disclosure, for any testing station, if the to-be-tested devices with different product information is switched on the testing station, any of the industrial personal computers corresponding to the testing station may call the automation program, stop the current testing program as needed, load a new overall testing procedure, and restart the corresponding performance testing.

In the embodiment of the present disclosure, any of the industrial personal computers may control the to-be-tested devices on the at least two testing stations to perform the same performance testing, and any of the industrial personal computers may control the to-be-tested devices on the at least two testing stations to perform the different performance testing, which is related to the product information of the to-be-tested devices on the at least two testing stations. In the case that the product information of the to-be-tested devices on the at least two testing stations is the same, any of the industrial personal computers may control the to-be-tested devices on the at least two testing stations to perform the performance testing of the same overall testing procedure. In the case that the product information varies among the to-be-tested devices on the at least two testing stations, any of the industrial personal computers may control the to-be-tested devices on the at least two testing stations to perform the performance testing of the different overall testing procedure.

It may be understood that the to-be-tested devices on the at least two testing stations are simultaneously controlled to perform performance testing through any of the industrial personal computers, and the overall testing procedures corresponding to the at least two testing stations may be different. In this way, different testing tasks are performed according to different to-be-tested devices and testing requirements, which can help to improve production efficiency and diversity while ensuring testing accuracy and consistency.

In some embodiments of the present disclosure, an identification label is affixed to the to-be-tested devices; and each testing workstation further includes: recognition equipment, configured to recognize the identification label on the to-be-tested device.

In the embodiment of the present disclosure, in order to acquire the product information of the to-be-tested devices through any of the industrial personal computers, the to-be-tested device on each testing workstation should have identification information, and the identification information contains the product information of the to-be-tested devices and is used to distinguish the different to-be-tested devices. Here, the above identification information may be presented in a form of the identification label.

In the embodiment of the present disclosure, the identification label is a small label or sticker that carries the product information of the to-be-tested devices. The identification label may be represented in a mode of a serial number, a batch number, a barcode label, a quick response code (QR) label, a radio-frequency identification (RFID) label, etc. The embodiment of the present disclosure does not impose any limitations on the representation of the identification label, which can specifically be selected according to actual applications.

In the embodiment of the present disclosure, the identification label may be affixed or attached on a housing, surface or specific part of the to-be-tested devices. It should be noted that the identification label should be placed in a position that is easy to scan or recognize. In addition, the identification label may be affixed on the to-be-tested devices through label glue or double-sided tape. Alternatively, a self-adhesive identification label may also be used directly. The embodiment of the present disclosure does not impose any limitations on this, which can specifically be selected according to the actual application scenario.

In the embodiment of the present disclosure, the recognition equipment may be arranged on each testing station to facilitate recognition of the identification label on the to-be-tested device on the testing station, thereby acquiring the product information of the to-be-tested devices.

In the embodiment of the present disclosure, the recognition equipment may be a barcode scanning gun, a sensor, a barcode scanner, a QR code scanner, an RFID reader-writer, optical character recognition equipment, etc. The barcode scanning gun usually use laser or an image scanning technology to read the information in the identification label. Specifically, after the barcode scanning gun is aligned with the identification label on the to-be-tested device, the barcode scanning gun will quickly capture and parse the product information on the identification label. It should be noted that the embodiment of the present disclosure does not impose any limitations on the recognition equipment, which can specifically be selected according to the actual application scenario.

In some embodiments of the present disclosure, the implementation of acquiring the production information of the to-be-tested devices on the at least two testing stations through any of the industrial personal computers in S201 may include S2011 to S2012:
S2011, in a case that the to-be-tested device arrives at any of the at least two testing stations, the identification label of the to-be-tested device on any testing station is read through the recognition equipment corresponding to any testing station.

In the embodiment of the present disclosure, in a case that any of the industrial personal computers perceives that the to-be-tested device arrives at any of the at least two testing stations, the identification label of the to-be-tested device on any testing station is read through the recognition equipment corresponding to any testing station.

In the embodiment of the present disclosure, in a case that the identification label is affixed to the to-be-tested device on any testing station and any testing station is provided with the recognition equipment, the recognition equipment will read the identification label on the to-be-tested device on any testing station.

It can be understood that in the embodiments of the present disclosure, on the one hand, the automatic recognition equipment reads the identification label and automatically transmits the product information without the need to manually record and enter data, thereby reducing manual operations and potential errors, and improving the efficiency of the production line. On the other hand, automatic label reading and information transmission reduce the risk of data entry errors and ensure the accuracy of product information. On the other hand, automated data collection and transmission reduces manual recording and data processing time, allowing operators to focus on more important tasks.

S2012, the identification label of the to-be-tested devices is parsed through the recognition equipment so as to acquire the product information of the to-be-tested devices, and the product information of the to-be-tested devices is transmitted to any of the industrial personal computers corresponding to any testing station, such that any of the industrial personal computers acquires the product information of the to-be-tested devices on the at least two testing stations.

In the embodiment of the present disclosure, after the recognition equipment corresponding to any testing station reads the identification label on the to-be-tested device, the recognition equipment parses the identification label on the to-be-tested device to acquire the product information of the to-be-tested devices. Furthermore, the identification equipment will send the product information of the to-be-tested devices to the corresponding industrial personal computer to achieve the acquisition of the product information on the plurality of testing stations, which will help improve the efficiency of the production line, data consistency and controllability of the production process.

It may be understood that on the one hand, through the automatic reading of the identification label, information transmission and data management of the industrial personal computer, more efficient, more accurate and more controllable production line operations may be achieved. On the other hand, one industrial personal computer may acquire the product information between the at least two testing stations, so as to achieve a higher degree of collaborative work and resource sharing, thereby improving the product quality and production efficiency, and reducing errors and costs.

In some embodiments of the present disclosure, each testing workstation further includes: verification equipment, configured to verify the product information of the to-be-tested devices. Based on Fig. 1, as shown in Fig. 2, the implementation of S102 may include S103 to S106:
S103, in a case that any of the industrial personal computers and the at least one testing instrument are in a connected state and the at least one testing instrument and the at least two testing stations are in a connected state, the product information of the to-be-tested devices on the at least two testing stations are transmitted to the verification equipment through any of the industrial personal computers.

In the embodiment of the present disclosure, each testing workstation is internally provided with the a verification equipment to verify the product information of the to-be-tested devices.

It should be noted that the verification equipment may be specialized hardware equipment or a software module integrated in any of the industrial personal computers, and the embodiment of the present disclosure does not impose any limitations on this.

For example, in a case that the verification equipment is hardware equipment, the verification equipment may be a manufacturing execution system (MES).

In the embodiment of the present disclosure, after any of the industrial personal computers receives the product information of the to-be-tested devices transmitted by the recognition equipment on any testing station, any of the industrial personal computers transmits the product information of the to-be-tested devices to the verification equipment.

In the embodiment of the present disclosure, a data transmission channel between any of the industrial personal computers and the verification equipment may be implemented through a local area network (LAN) connection, a universal serial bus (USB) connection or other communication modes, and the embodiment of the present disclosure does not impose any limitations on this.

S104, the product information of the to-be-tested devices on the at least two testing stations is verified through the verification equipment so as to obtain verification results, wherein the verification results are used for indicating whether the product information of the to-be-tested devices is compliant.

In the embodiment of the present disclosure, after the verification equipment acquires the product information of the to-be-tested devices, the verification equipment verifies the product information of the to-be-tested devices according to a preset verification rule to obtain the verification results. The preset verification rules are used to detect whether the product information of the to-be-tested devices meets the expected standards.

In the embodiment of the present disclosure, the preset verification rules include at least one of the following: product information format verification, product information validity verification, product information consistency verification, product information range verification, repeatability verification, completeness verification, logical verification, historical data verification, security verification and communication verification.

In the embodiment of the present disclosure, the verification equipment generates the verification results after verifying the product information of the to-be-tested devices according to the preset verification rules. The verification results are used to indicate whether the to-be-tested devices are compliant. Exemplarily, the verification results may be divided into two situations: pass and fail.

The following explains the preset verification rules listed above:
1) Product information format verification is used to check whether a format of the product information conforms to a specific pattern or coding specification. For example, a product serial number must be composed of numbers and letters, and a length must be a specific number of characters.
2) Product information validity verification is used to verify whether the product information exists in a product database to ensure that the product information is valid, which can include checking whether a model, a project or blueprint information is valid.
3) Product information consistency verification is used to compare the consistency between the product information of the to-be-tested devices and the expected information. For example, whether the product information of the to-be-tested devices matches the information in a work order.
4) Product information range verification is used to check whether the product information is within a reasonable range. For example, whether a production date of the to-be-tested device is within a reasonable time range is checked.
5) Repeatability verification is used to prevent the same product information from being used multiple times. For example, whether the product information of the to-be-tested devices has been used on the production line is checked.
6) Integrity verification is used to ensure that all required product information has been provided. For example, whether a critical project or blueprint information is missing is checked.
7) Logical verification is used to verify whether a logical relationship between the product information is correct. For example, whether the product information matches specific process steps or testing requirements is checked.
8) Historical data verification is used to check whether the product information is consistent with previous production historical data. This helps ensure a consistent production process for the product.
9) Security verification is used to ensure that product information does not contain potential security issues or malicious code.
10) Communication verification is used to check integrity and accuracy of data during product information transmission to prevent data damage or loss.

It should be noted that the preset verification rules listed above are only an example and can be customized according to specific production needs and product characteristics. The definition of the preset verification rules is usually a part of configuration or programming in the manufacturing execution system to ensure accurate and consistent verification of the product information in the production process. The correct definition of the verification rules is conducive to maintaining product quality and data reliability.

It may be understood that the product information of the to-be-tested devices on the at least two testing stations is verified by the verification equipment, which can ensure that the product information of the to-be-tested devices is accurate, improve the controllability, quality and efficiency of a manufacturing process, and reduce production risks and costs, thereby reducing the risk of producing unaccepted product and improving the quality of produced products.

It may be understood that in the embodiment of the present disclosure, on the one hand, the automated transmission and verification process reduces the chance of human data input errors and improves the data accuracy. On the one hand, if the product information of the to-be-tested devices is non-compliant, the verification equipment may detect it immediately, avoiding downtime caused by discovering problems in subsequent production process. On the other hand, the automated verification process speeds up production and ensures that product information is compliant, thereby improving the production efficiency. On the other hand, the production of defective products is reduced, the cost of scrap and rework is reduced, and the manufacturing cost is reduced.

In some embodiments of the present disclosure, the implementation of verifying the production information of the to-be-tested devices on the at least two testing stations through the verification equipment so as to obtain the verification results in S104 may include S105 to S106:
S105, the verification equipment feeds the verification results of the to-be-tested devices on the at least two testing stations back to any corresponding industrial personal computer.

In the embodiment of the present disclosure, the verification equipment transmits the verification results of the to-be-tested devices to the corresponding industrial personal computer through a network or other communication modes. For example, it may be achieved by using standard communication protocols or customized data transmission methods.

In the embodiment of the present disclosure, any of the industrial personal computers, after receiving the verification structure of the to-be-tested devices sent by the verification equipment, may store the verification results in a database or a designated data storage location to facilitate recording and tracking of verification history. In addition, any of the industrial personal computers may further perform subsequent processing on the verification results, for example, associate the verification results with the product information and generate reports or charts for subsequent analysis.

In the embodiment of the present disclosure, in a case that the verification results indicate that the product information of the to-be-tested devices is not compliant, any of the industrial personal computers may trigger an alarm or notify relevant personnel to take appropriate measures, such as shutting down, rejecting manufacturing, or repairing.

S106, in a case that the verification results indicate that the product information of the to-be-tested devices on the at least two testing stations is compliant, a step of controlling the to-be-tested devices on the at least two testing stations to perform corresponding performance testing through any of the industrial personal computers is executed.

It may be understood that by feeding back the verification results of the to-be-tested devices to the industrial personal computer and deciding whether to perform the corresponding performance testing on the to-be-tested devices according to the verification results, real-time monitoring and management of the production quality can be achieved, and measures can be taken timely to ensure product compliance, thereby helping improve the controllability and traceability of the production line, and ensuring the product quality while reducing the production risks and costs.

It may be understood that in the embodiment of the present disclosure, on the one hand, the use of the verification equipment and feedback of the automated verification results ensure the consistency and reliability of quality control and reduce the possibility of human errors. On the one hand, the industrial personal computers may quickly decide whether to continue to perform performance testing according to the verification results. If the product information is compliant, the testing may be started immediately to save the time. On the one hand, by ensuring the compliance of the product information, performance testing can only target products that meet standards, reducing the production of substandard products. On the other hand, automatic control performance testing can improve the production efficiency, reduce the waiting time and downtime on the production line, and reduce the production of unqualified products and the number of discarded products, thereby reducing the production cost. On the other hand, through compliance verification and performance testing, it is ensured that the product quality reaches expected standards and improves the quality and reliability of the final product.

In some embodiments of the present disclosure, the at least two testing stations controlled by any of the industrial personal computers are respectively deployed on at least two transmission channels, and the at least two transmission channels are independent of each other.

It may be understood that in the embodiment of the present disclosure, the at least two testing stations are respectively deployed on the at least two independent transmission channels. On the one hand, different transmission channels may be configured to test different products or perform different quality control steps, thereby helping ensure the product quality. On the one hand, parallel processing of different products or procedures can increase the production line's capacity to meet more customer needs. On the one hand, if a procedure on a certain transmission channel takes more time, it will not affect the production process on other channels, reducing congestion on the production line. In addition, if the equipment or system of one transmission channel fails, other channels can continue to operate, ensuring that production is not greatly affected. Overall, deploying the different testing stations on the independent transmission channels provides higher production flexibility, reliability and efficiency, helping to meet complex manufacturing needs and reduce risks in production line operations.

In some embodiments of the present disclosure, as shown in Fig. 3, the implementation of determining the overall testing procedure for performance testing corresponding to to-be-tested devices on the at least two testing stations through any of the industrial personal computers, wherein the overall testing procedures for performance testing corresponding to the at least two testing stations are different in S1021 may include S301 or S302: S301, the to-be-tested device located on each testing station of the at least two transmission channels is controlled through any of industrial personal computers to simultaneously perform performance testing of respectively corresponding overall testing procedures.

In the embodiment of the present disclosure, the at least two testing stations are deployed on the at least two transmission channels respectively, so that different to-be-tested devices or different overall testing procedures can be performed in parallel without interfering with each other, thereby accelerating the production process, and improving the production efficiency.

Exemplarily, the at least two testing stations controlled by any of the industrial personal computers include: a testing station A and a testing station B. The testing station A is deployed on a first transmission channel, and the testing station B is deployed on a second transmission channel. The first transmission channel and the second transmission channel are independent of each other. At this time, the overall testing procedures of the to-be-tested devices a located on the testing station A and the to-be-tested devices b located on the testing station B may be different. Any of the industrial personal computers may simultaneously or separately control the to-be-tested devices a and the to-be-tested devices b to perform performance testing of the different overall testing procedures.

In the embodiment of the present disclosure, any of the industrial personal computers may direct the transportation equipment to transport the to-be-tested devices to the testing station on the corresponding transmission channel according to the product information of the to-be-tested devices, so as to facilitate performing of the corresponding performance testing.

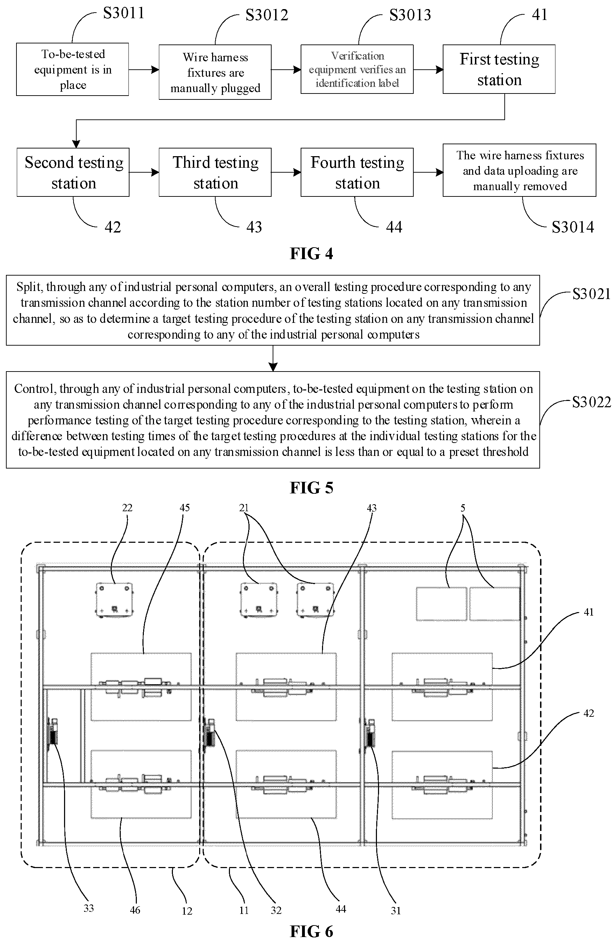

Exemplarily, Fig. 4 is a fourth schematic flow diagram of an optional testing method provided by an embodiment of the present disclosure. As shown in Fig. 4, the testing method includes S3011 to S3014:
S3011, the to-be-tested devices are in place.

In the embodiment of the present disclosure, the to-be-tested devices are transported to a designated location by the transportation equipment, so that the to-be-tested devices are in place.

S3012, wire harness fixtures are manually plugged.

In the embodiment of the present disclosure, after the to-be-tested devices are in place, an operator may plug the wire harness fixtures.

S3013, the verification equipment verifies the identification label.

In the embodiment of the present disclosure, the verification equipment verifies the to-be-tested devices to ensure the correctness of the product information of the to-be-tested devices.

In the embodiment of the present disclosure, in a case that the product information of the to-be-tested devices is compliant, the transportation equipment may transport the different to-be-tested devices to first testing station 41, second testing station 42, third testing station 43 and fourth testing station 44. In this way, any of the industrial personal computers may control the to-be-tested devices located on the four testing stations to simultaneously perform performance testing of respectively corresponding overall testing procedures.

S3014, the wire harness fixtures and data uploading are manually removed.

In the embodiment of the present disclosure, after completing the performance testing of the to-be-tested devices, the operator may remove the wire harness fixtures and data uploading.

S302, through any of the industrial personal computers, the to-be-tested device located on each testing station of any transmission channel is controlled to sequentially perform performance testing of the respectively corresponding target testing procedures, wherein the target testing procedure belongs to a partial testing procedure in the overall testing procedure; and the overall testing procedure corresponding to any transmission channel is a sum of the target testing procedures corresponding to the individual testing stations on any transmission channel.

In the embodiment of the present disclosure, for the individual testing stations located on the same transmission channel, any of the industrial personal computers may control the to-be-tested devices located on the individual testing stations of the same transmission channel to sequentially perform the performance testing of the respectively corresponding target testing procedures.

Exemplarily, the testing stations on any transmission channel include: a testing station A and a testing station C, then any of the industrial personal computers may control the to-be-tested devices a to first perform the first target testing procedure on the testing station A, then, the to-be-tested devices a is transported to the testing station C, and the next industrial personal computer continues to control the to-be-tested devices a to perform the second target testing procedure on the testing station C. At this time, a sum of the first target testing procedure and the second target testing procedure is the overall testing procedure corresponding to the first transmission channel.

It should be noted that in S1022 the implementation of controlling the to-be-tested devices on the at least two testing stations to perform corresponding performance testing according to the overall testing procedures respectively corresponding to the at least two testing stations may include S301 or S302, that is, S301 and S302 are parallel solutions, and either can be executed. Any of the industrial personal computers can execute step S301 or S302.

It may be understood that on the one hand, any of the industrial personal computers can simultaneously control the performance testing of the plurality of testing stations, reduce a waiting time of the testing procedure and improve the overall efficiency of the production line. On the other hand, the individual testing stations on any transmission channel can sequentially perform testing, thereby shortening the time of the entire testing process and improving the overall efficiency of the production line.

In some embodiments of the present disclosure, as shown in Fig. 5, in S302 the implementation of controlling, through any of the industrial personal computers, the to-be-tested device located on each testing station of any transmission channel to sequentially perform performance testing of the respectively corresponding target testing procedures may include S3021 to S3022: S3021, the overall testing procedure corresponding to any transmission channel is split through any of the industrial personal computers according to the station number of the testing stations located on any transmission channel, so as to determine the target testing procedure of the testing station on any transmission channel corresponding to any of the industrial personal computers.

In the embodiment of the present disclosure, the testing time of the performance testing corresponding to the to-be-tested device on any transmission channel can be acquired according to historical data, simulated testing, or actual testing.

In the embodiment of the present disclosure, any of the industrial personal computers decomposes the overall testing procedure into sub-testing procedures that are consistent with the number of the testing stations according to the station number of the testing stations on any transmission channel, ensuring that time and resource requirements of each sub-testing procedure can be met. Any of the industrial personal computers may allocate the target testing procedures to each testing station in sequence to ensure completion within the performance testing time.

It may be understood that splitting the corresponding overall testing procedures through any of the industrial personal computers will help optimize production line operations and improve the production efficiency.

S3022, the to-be-tested device on the testing station on any transmission channel corresponding to any of the industrial personal computers is controlled through any of industrial personal computers to perform performance testing of the target testing procedure corresponding to the testing station, wherein a difference between testing times of the target testing procedures at the individual testing stations for the to-be-tested device located on any transmission channel is less than or equal to a preset threshold.

In the embodiment of the present disclosure, the preset threshold is a value set by the implementation. Exemplarily, the preset threshold is 2 seconds.

In the embodiment of the present disclosure, the testing times of the target testing procedures at the individual testing stations of the to-be-tested device located on any transmission channel tends to be the same.

It may be understood that when the testing times at the individual testing stations tend to be the same, the entire testing process will be more simplified and efficient, because there is no need for special coordination and scheduling to ensure that the testing times at the individual testing stations are close. This will help improve the production efficiency and ensure that the testing process meets the product quality requirements.

It may be understood that on the one hand, by splitting the overall testing procedure according to the number of the testing stations on any transmission channel, performance testing of the plurality of testing stations can be performed in parallel, thereby greatly improving the testing efficiency and reducing the testing time. On the other hand, any testing station on any transmission channel does not need to wait for other testing stations to complete the testing, thereby reducing an idle time of the testing equipment and increasing resource utilization.

In some embodiments of the present disclosure, any testing workstation is a first testing workstation, configured to perform product end-of-line performance testing on the to-be-tested devices; the at least two transmission channels include: a first transmission channel and a second transmission channel; any of the industrial personal computers is a first industrial personal computer; and the at least two testing stations corresponding to the first industrial personal computer include: a first testing station located on the first transmission channel and a second testing station located on the second transmission channel.

In the embodiment of the present disclosure, the product end-of-line (EOL) performance testing refers to testing performed at a final stage of a product manufacturing line to verify whether the final performance and quality of the product comply with specifications and standards.

In the embodiment of the present disclosure, the first testing workstation has two transmission channels, namely, a first transmission channel and a second transmission channel, wherein the first transmission channel has a first testing station, the second transmission channel has a second testing station, and the first industrial personal computers correspond to these two testing stations. The main purpose of this layout is to perform testing works on different channels simultaneously to improve the production efficiency and flexibility. This settings may be used to simultaneously test different models or specifications of products, or to shunt different products on the production line.

It may be understood that through the above settings, the two transmission channels may be fully utilized to simultaneously test the products on different channels, thus increasing the utilization of the production line and improving the flexibility of the production line. At the same time, through the automated control of the industrial personal computers, the consistency and reliability of the testing can be ensured.

In some embodiments of the present disclosure, in S3022 the implementation of controlling, through any of the industrial personal computers, the to-be-tested device on the testing station on any transmission channel corresponding to any of the industrial personal computers to perform performance testing of the target testing procedure corresponding to the testing station may include S401 to S402:
S401, first to-be-tested device is transported to the first testing station through the transportation equipment; and in a case that the first industrial personal computer perceives that the first to-be-tested device arrives at the first testing station, the first to-be-tested device is controlled through the first industrial personal computer to perform product end-of-line performance testing of the first target testing procedure corresponding to the first testing station.

In the embodiment of the present disclosure, the first industrial personal computer must have the ability to perceive that the equipment is in place, and usually detects whether the equipment has reached the first testing station through a sensor or other detection apparatuses.

In the embodiment of the present disclosure, the first to-be-tested device is transmitted from a starting position of the production line or the previous testing workstation to the first testing station using the transportation equipment. When the first industrial personal computer perceives that the first to-be-tested device arrives at the first testing station, the first industrial personal computer triggers a testing program for the corresponding first target testing procedure for performance testing. In the above testing process, the first industrial personal computer collects and records the performance data of the first to-be-tested device, including testing results and various performance parameters. Further, the first industrial personal computer analyzes the testing data of the first to-be-tested device. If the performance of the first to-be-tested device meets the specification requirements, the first industrial personal computer may mark the first to-be-tested device as qualified. If the performance of the first to-be-tested device does not meet the specification requirements, the first industrial personal computer can take the corresponding measures.

In the embodiment of the present disclosure, the first industrial personal computer may further store the testing results of the first to-be-tested device to facilitate subsequent quality management and traceability.

It may be understood that by generating detailed testing reports, data traceability can be easily performed for quality control and improvements when needed. The automatic testing process reduces the risk of human errors and improves the accuracy of the testing results.

In the embodiment of the present disclosure, if the first to-be-tested device passes the testing, the first industrial personal computer may control the transportation equipment to move it out of the first testing station, thereby completing the product end-of-line performance testing.

S402, second to-be-tested device is transported to the second testing station through the transportation equipment; and in a case that the first industrial personal computer perceives that the second to-be-tested device arrives at the second testing station, the second to-be-tested device is controlled through the first industrial personal computer to perform product end-of-line performance testing of a second target testing procedure corresponding to the second testing station.

Similarly, the second to-be-tested device is transmitted from a starting position of the production line or the previous testing workstation to the second testing station using the transportation equipment. When the first industrial personal computer perceives that the second to-be-tested device arrives at the second testing station, the first industrial personal computer triggers the testing program for the corresponding first target testing procedure for performance testing.

It may be understood that the first industrial personal computer may allow different performance testing on the to-be-tested devices on the two different transmission channels at the same time, depending on its product information and overall testing procedures, so as to improve the efficiency and flexibility of the production line.

In some embodiments of the present disclosure, the first target testing procedure is a partial testing procedure in the first overall testing procedure corresponding to the first transmission channel, and the second target testing procedure is a partial testing procedure in the second overall testing procedure corresponding to the second transmission channel; and first overall testing procedure is related to product information of the first to-be-tested device, and the second overall testing procedure is related to product information of the second to-be-tested device.

It should be noted that S401 and S402 can be executed simultaneously or sequentially. The embodiment of the present disclosure does not impose any limitations on the execution order of S401 and S402.

It may be understood that on the one hand, the performance testing is simultaneously performed on the to-be-tested devices on the two different transmission channels, which reduces the waiting time of the testing procedure and thus speeds up the production. On the other hand, customized performance testing can be performed on different types of to-be-tested devices based on the product information on the different transmission channels and the different overall testing procedures, which improves the flexibility and adaptability of the production line. In addition, since the testing procedures are performed in parallel, the number of the testing equipment and the industrial personal computers can be reduced, thereby reducing equipment and labor costs. On the other hand, by processing different testing procedures in parallel, the idle time on the production line is reduced, and the production process is made more continuous.

In some embodiments of the present disclosure, the first testing workstation further includes: a second industrial personal computer; and the testing method further includes:
after the first to-be-tested device and/or the second to-be-tested device completes the product end-of-line performance testing of the target testing procedure corresponding to the first industrial personal computer, the first to-be-tested device and/or the second to-be-tested device are/is controlled through the second industrial personal computer to perform the product end-of-line performance testing of the testing procedure other than the target testing procedure corresponding to the first industrial personal computer.

It may be understood that by controlling, through the second industrial personal computer, the first to-be-tested device and/or the second to-be-tested device to perform the product end-of-line performance testing of the testing procedure other than the target testing procedure corresponding to the first industrial personal computer, different industrial personal computers may be made to control different testing procedures for the product end-of-line performance testing in parallel, thereby greatly improving the testing efficiency and reducing the testing time.

In some embodiments of the present disclosure, the at least two testing stations corresponding to the second industrial personal computer include: a third testing station located on the first transmission channel and a fourth testing station located on the second transmission channel, the third testing station is deployed following the first testing station, and the fourth testing station is deployed following the second testing station.

In some embodiments of the present disclosure, the implementation of controlling, through the second industrial personal computer, the first to-be-tested device and/or the second to-be-tested device to perform the product end-of-line performance testing of the testing procedure other than the target testing procedure corresponding to the first industrial personal computer includes S403 and S406:
S403, the first to-be-tested device is transported to the third testing station through the transportation equipment.
S404, in a case that the second industrial personal computer perceives that the first to-be-tested device arrives at the third testing station, the first to-be-tested device is controlled through the second industrial personal computer to perform product end-of-line performance testing of a third target testing procedure corresponding to the third testing station.
S405, the second to-be-tested device is transported to the second testing station through the transportation equipment.
S406, in a case that the second industrial personal computer perceives that the second to-be-tested device arrives at the fourth testing station, the second to-be-tested device is controlled through the second industrial personal computer to perform product end-of-line performance testing of a fourth target testing procedure corresponding to the fourth testing station.

In some embodiments of the present disclosure, a sum of the first target testing procedure and the third target testing procedure is the first overall testing procedure; and a sum of the second target testing procedure and the fourth target testing procedure is the second overall testing procedure.

In the embodiment of the present disclosure, the first to-be-tested device completes the product end-of-line performance testing of the first target testing procedure and is transported to the third testing station. In a case that the second industrial personal computer perceives that the first to-be-tested device arrives at the third testing station, the first to-be-tested device is controlled through the second industrial personal computer to perform the product end-of-line performance testing of the third target testing procedure corresponding to the third testing station. After the performance testing is completed, the second industrial personal computer may collect testing data and results. Similarly, the second to-be-tested device completes the product end-of-line performance testing of the second target testing procedure and is transported to the fourth testing station. In a case that the second industrial personal computer perceives that the second to-be-tested device arrives at the fourth testing station, the second to-be-tested device is controlled through the second industrial personal computer to perform the product end-of-line performance testing of a third target testing procedure corresponding to the fourth testing station.

It should be noted that S403 and S404 as well as S405 and S406 can be executed simultaneously or sequentially. The embodiment of the present disclosure does not impose any limitations on this.

It may be understood that on the one hand, the to-be-tested devices may be tested in parallel at different testing stations without waiting for one equipment to complete all testing, allowing the plurality of testing procedures to be performed simultaneously, thereby improving the efficiency of the production line. On the other hand, the production cost can be reduced by maximizing the use of the existing equipment and resources. In addition, the unnecessary production line downtime cost caused by the waiting time and changeover time is saved. On the other hand, since any of the industrial personal computers can be configured to perform different testing procedures for the at least two testing stations, the production line can easily adapt to different models or blueprints of products without the need for large-scale production line reconstruction or changes.

In some embodiments of the present disclosure, the at least one testing workstation further includes: a second testing workstation, configured to perform direct current resistance performance testing on the to-be-tested devices; the second testing workstation is a testing workstation following the first testing workstation; the second testing workstation includes: a third industrial personal computer; and the testing method further includes:
after the first to-be-tested device and/or the second to-be-tested devices complete(s) the product end-of-line performance testing of the first testing workstation, the first to-be-tested device and/or the second to-be-tested devices are/is controlled through the third industrial personal computer to perform direct current resistance performance testing.

It may be understood that by controlling, through the third industrial personal computer, the first to-be-tested device and/or the second to-be-tested device to perform direct current resistance performance testing, different industrial personal computers may be made in parallel to control different testing procedures for the different types of performance testing, thereby greatly improving the testing efficiency and reducing the testing time.

In some embodiments of the present disclosure, the at least two testing stations corresponding to the third industrial personal computer include: a fifth testing station located on the first transmission channel and a sixth testing station located on the second transmission channel, the fifth testing station is deployed following the third testing station, and the sixth testing station is deployed following the fourth testing station; and the implementation of controlling, through the third industrial personal computer, the first to-be-tested device and/or the second to-be-tested device to perform direct current resistance performance testing may include S501 to S504:
S501, the first to-be-tested device is transported to the fifth testing station through the transportation equipment.

In the embodiment of the present disclosure, the direct current resistance (DCR) performance testing is used to measure a resistance value of the to-be-tested devices to ensure that it meets the design requirements.

S502, in a case that the third industrial personal computer perceives that the first to-be-tested device arrives at the fifth testing station, the first to-be-tested device is controlled through the third industrial personal computer to perform direct current resistance performance testing of a third overall testing procedure corresponding to the fifth testing station.

S503, the second to-be-tested device is transported to the sixth testing station through the transportation equipment.

S504, in a case that the third industrial personal computer perceives that the second to-be-tested device arrives at the sixth testing station, the second to-be-tested device is controlled through the third industrial personal computer to perform direct current resistance performance testing of a fourth overall testing procedure corresponding to the sixth testing station.

In some embodiments of the present disclosure, the third overall testing procedure is related to the product information of the first to-be-tested device, and the fourth overall testing procedure is related to the product information of the second to-be-tested device.

It may be understood that on the one hand, by simultaneously executing the plurality of testing procedures, the entire testing cycle is reduced, and the testing efficiency of the production line can be improved. On the other hand, the production cost can be reduced by maximizing the use of the existing equipment and resources. In addition, the unnecessary production line downtime cost caused by the waiting time and changeover time is saved. On the other hand, different testing stations can be compatible with different blueprint projects for different performance testing, thereby achieving non-stop changeover to increase the production line utilization.

It should be noted that S501 and S502 as well as S503 and S504 can be executed simultaneously or sequentially. The embodiment of the present disclosure does not impose any limitations on this.

**In** some embodiments of the present disclosure, the at least one testing workstation further includes: a third testing workstation, configured to perform air tightness performance testing on the to-be-tested devices; and the third testing workstation is a testing workstation prior to the first testing workstation; and before controlling, through any of the industrial personal computers, the to-be-tested devices on the at least two testing stations to perform the product end-of-line performance testing, the testing method further includes:
the to-be-tested devices on the at least two testing stations is controlled through the industrial personal computer in the third testing workstation to perform air tightness performance testing.

In the embodiment of the present disclosure, the air tightness testing may be used to detect whether there is an air leakage problem in the to-be-tested devices to ensure air tightness of the product.

It may be understood that by processing the different testing procedures in parallel, the idle time on the production line is reduced, and the production process is made more continuous, thereby achieving non-stop changeover to increase the production line utilization.

To implement the testing method of the embodiment of the present disclosure, an embodiment of the present disclosure further provides a testing system. The testing system includes: at least one testing workstation, configured to perform at least one performance testing on to-be-tested devices. Each testing workstation includes:
at least one testing instrument, at least one industrial personal computer, and at least two testing stations respectively corresponding to each industrial personal computer;
any of the industrial personal computers is connected with the at least one testing instrument;
the at least one testing instrument is connected with the at least two testing stations; and
any of the industrial personal computers is configured to control the to-be-tested devices on the at least two testing stations to perform corresponding performance testing based on the at least one testing instrument, wherein the at least two testing stations are independent of each other.

In the embodiment of the present disclosure, any of the industrial personal computers can independently control the at least two testing stations, which can be realized through a multi-thread or parallel processing function of the industrial control software. In this way, it may be ensured that any of the industrial personal computers can simultaneously test the to-be-tested devices on the at least two testing stations.

In the embodiment of the present disclosure, the at least one testing instrument is equipment used to perform various performance testing tasks, such as an oscilloscope, a multimeter, and a functional tester. The at least one testing instrument is usually connected with any of the industrial personal computers to receive testing commands and feed back testing results to any of the industrial personal computers for analysis and recording.

In the embodiment of the present disclosure, a connection mode among any of the industrial personal computers, the at least one testing instrument, and the at least two testing workstations may be manual wire harness fixtures, or an automated connection mode. The embodiment of the present disclosure does not impose any limitations on this.

It may be understood that in a process of controlling the to-be-tested devices on the at least two testing stations through any of the industrial personal computers to perform corresponding performance testing, an automated testing process is realized through a script or program in any of the industrial personal computers. In this way, performance testing of batches of to-be-tested devices can be achieved, thereby reducing operator intervention. In addition, by controlling the to-be-tested devices on the at least two independent testing stations through any of the industrial personal computers to perform corresponding performance testing, the production efficiency and the testing consistency can be improved, which is suitable for large-scale manufacturing and testing processes, and can increase the production capacity.

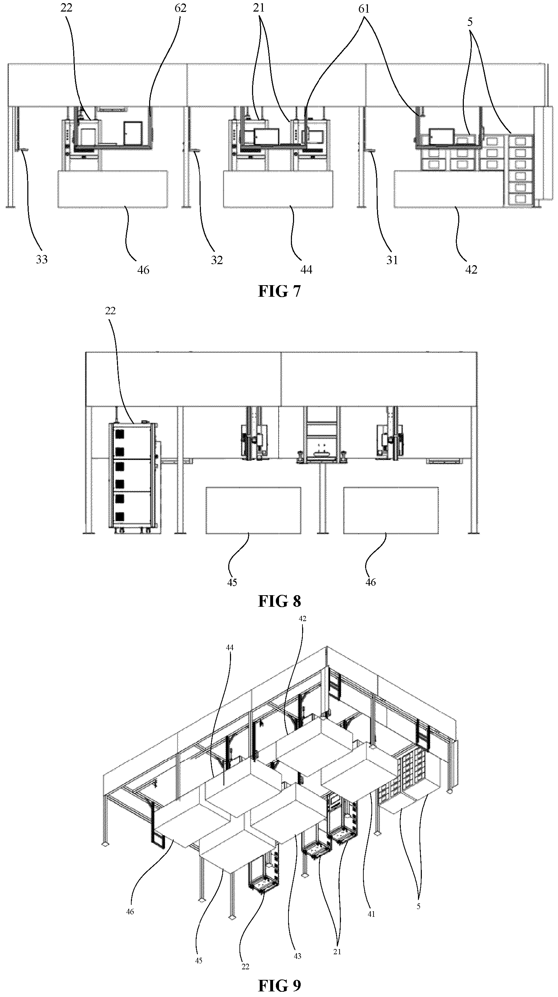

In the embodiment of the present disclosure, Fig. 6 is a top view of an optional testing system provided by an embodiment of the present disclosure. Fig. 7 is a front view of an optional testing system provided by an embodiment of the present disclosure. Fig. 8 is a left view of an optional testing system provided by an embodiment of the present disclosure. Fig. 9 is a stereogram of an optional testing system provided by an embodiment of the present disclosure. Combining Fig. 6, Fig. 7, Fig. 8, and Fig. 9, in some embodiments of the present disclosure, the at least one testing workstation includes: first testing workstation 11 and second testing workstation 12, and second testing workstation 12 is a testing workstation following first testing workstation 11; first testing workstation 11 is configured to perform product end-of-line performance testing on the to-be-tested devices; and second testing workstation 12 is configured to perform direct current resistance performance testing on the to-be-tested devices.

In some embodiments of the present disclosure, first testing workstation 11 includes: first industrial personal computer 31, second industrial personal computer 32, first testing station 41, second testing station 42, third testing station 43 and fourth testing station 44; the at least two transmission channels include: a first transmission channel and a second transmission channel; third testing station 43 is deployed following first testing station 41, and fourth testing station 44 is deployed following second testing station 42; first testing station 41 and third testing station 43 are deployed on the first transmission channel; and second testing station 42 and fourth testing station 44 are deployed on the second transmission channel.

First industrial personal computer 31 is configured to control first to-be-tested device to perform product end-of-line performance testing on a first target testing procedure corresponding to first testing station 41, and control second to-be-tested device to perform product end-of-line performance testing on a second target testing procedure corresponding to second testing station 42.

Second industrial personal computer 32 is configured to control the first to-be-tested device to perform product end-of-line performance testing of a third target testing procedure corresponding to third testing station 43 and control the second to-be-tested device to perform product end-of-line performance testing of a fourth target testing procedure corresponding to fourth testing station 44, wherein
a sum of the first target testing procedure and the third target testing procedure is a first overall testing procedure corresponding to the first transmission channel; a sum of the second target testing procedure and the fourth target testing procedure is a second overall testing procedure corresponding to the second transmission channel; and the first overall testing procedure is related to product information of the first to-be-tested device, and the second overall testing procedure is related to product information of the second to-be-tested device.

In the embodiment of the present disclosure, the first to-be-tested device is transported to first testing station 41 through the transportation equipment; in a case that first industrial personal computer 31 perceives that the first to-be-tested device arrives at first testing station 41, the first to-be-tested device is controlled through first industrial personal computer 31 to perform product end-of-line performance testing of the first target testing procedure corresponding to first testing station 41; after the first to-be-tested device completes the product end-of-line performance testing of the first target testing procedure, the first to-be-tested device is transported to third testing station 43 through the transportation equipment; and in a case that second industrial personal computer 32 perceives that the first to-be-tested device arrives at third testing station 43, the first to-be-tested device is controlled through second industrial personal computer 32 to perform the product end-of-line performance testing of the third target testing procedure corresponding to third testing station 43. And/or, the second to-be-tested device is transported to second testing station 42 through the transportation equipment; in a case that first industrial personal computer 31 perceives that the second to-be-tested device arrives at second testing station 42, the second to-be-tested device is controlled through first industrial personal computer 31 to perform the product end-of-line performance testing of the first target testing procedure corresponding to second testing station 42; after the second to-be-tested device completes the product end-of-line performance testing of the second target testing procedure, the second to-be-tested device is transported to fourth testing station 44 through the transportation equipment; and in a case that second industrial personal computer 32 perceives that the second to-be-tested device arrives at fourth testing station 44, the second to-be-tested device is controlled through second industrial personal computer 32 to perform the product end-of-line performance testing of the fourth target testing procedure corresponding to fourth testing station 44.

It may be understood that on the one hand, the to-be-tested devices may be tested in parallel at different testing stations without waiting for one equipment to complete all testing, allowing the plurality of testing procedures to be performed simultaneously, thereby improving the efficiency of the production line. On the other hand, since any of the industrial personal computers can be configured to perform different testing procedures for the at least two testing stations, the production line can easily adapt to different models or blueprints of products without the need for large-scale production line reconstruction or changes.

In some embodiments of the present disclosure, second testing workstation 12 includes: third industrial personal computer 33, fifth testing station 45 and sixth testing station 46; second testing workstation 12 is a testing workstation following first testing workstation 11; the at least two transmission channels include: a first transmission channel and a second transmission channel; fifth testing station 45 is deployed following third testing station 43, and sixth testing station 46 is deployed following fourth testing station 44; fifth testing station 45 is deployed on the first transmission channel; and sixth testing station 46 is deployed on the second transmission channel.

Third industrial personal computer 33 is configured to control the first to-be-tested device to perform direct current resistance performance testing of a third overall testing procedure corresponding to fifth testing station 45 and control the second to-be-tested device to perform direct current resistance performance testing of a fourth overall testing procedure corresponding to sixth testing station 46, wherein
the third overall testing procedure is related to product information of the first to-be-tested device, and the fourth overall testing procedure is related to product information of the second to-be-tested device.

In the embodiment of the present disclosure, after the first to-be-tested device completes the product end-of-line performance testing of first testing workstation 11, the first to-be-tested device is transported to fifth testing station 45 through the transportation equipment; in a case that third industrial personal computer 33 perceives that the first to-be-tested device arrives at fifth testing station 45, the first to-be-tested device is controlled through third industrial personal computer 33 to perform the direct current resistance performance testing of the third target testing procedure corresponding to fifth testing station 45; and/or, after the second to-be-tested device completes the product end-of-line performance testing of first testing workstation 11, the second to-be-tested device is transported to sixth testing station 46 through the transportation equipment; and in a case that third industrial personal computer 33 perceives that the second to-be-tested device arrives at sixth testing station 46, the second to-be-tested device is controlled through third industrial personal computer 33 to perform the direct current resistance performance testing of the fourth overall testing procedure corresponding to sixth testing station 46.

It may be understood that on the one hand, by simultaneously executing the plurality of testing procedures, the entire testing cycle is reduced, and the testing efficiency of the production line can be improved. On the other hand, the production cost can be reduced by maximizing the use of the existing equipment and resources.

In some embodiments of the present disclosure, the at least one testing workstation further includes: a third testing workstation, configured to perform air tightness testing on the to-be-tested devices; and the third testing workstation is a testing workstation prior to first testing workstation 11.

In the embodiment of the present disclosure, through the industrial personal computer in the third testing workstation, the to-be-tested devices on the at least two testing stations is controlled to perform air tightness performance testing.

In some embodiments of the present disclosure, the testing system further includes: an instrument cabinet; and the at least one testing instrument in the at least one testing workstation is integrated in the instrument cabinet and configured to perform corresponding performance testing on the to-be-tested devices.

In some embodiments of the present disclosure, the instrument cabinet includes: first instrument cabinet 21 and second instrument cabinet 22;
first instrument cabinet 21 is located in first testing workstation 11, the at least one testing instrument in first testing workstation 11 is integrated in first instrument cabinet 21, and instruments in first instrument cabinet 21 are configured to perform product end-of-line performance testing on the to-be-tested devices on the at least two testing stations in first testing workstation 11; and
second instrument cabinet 22 is located in second testing workstation 12, the at least one testing instrument in second testing workstation 12 is integrated in second instrument cabinet 22, and instruments in second instrument cabinet 22 are configured to perform direct current resistance performance testing on the to-be-tested devices on the at least two testing stations in second testing workstation 12.

In some embodiments of the present disclosure, the testing system further includes: material cabinet 5, configured to house wire harness fixtures.

In the embodiment of the present disclosure, material cabinet 5 refers to equipment configured to store, organize and manage various production line fixtures, tools and materials. Material cabinet 5 can provide a safe storage environment to protect the wire harness fixtures and other tools from damage, contamination or loss. Material cabinet 5 is usually designed as a plurality of drawers, partition boards or shelves, which can help classify and organize the wire harness fixtures in an orderly manner. In this way, an operator may easily find the fixtures they need, thereby improving the working efficiency. Material cabinet 5 is often equipped with a locking mechanism that prevent unauthorized personnel from accessing the fixtures and materials, which helps improve security and prevent theft or improper use.

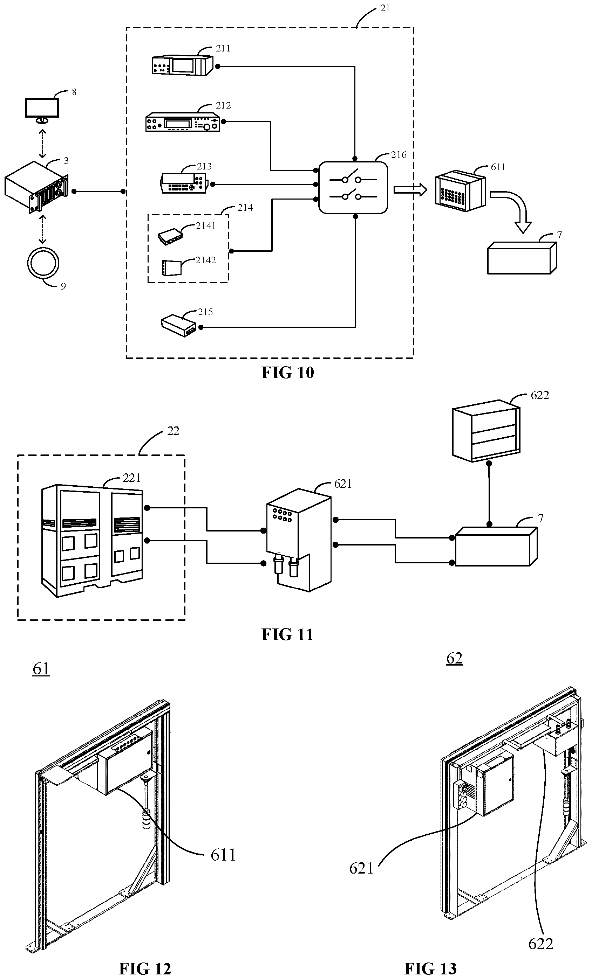

In some embodiments of the present disclosure, Fig. 10 is a schematic connection diagram of a testing instrument of an optional first testing workstation provided by an embodiment of the present disclosure. As shown in Fig. 10, first instrument cabinet 21 includes:
relay 216, configured to control flowing of a current in a circuit according to a voltage level;
withstand voltage tester 211, configured to detect insulation of the to-be-tested devices 7, wherein a first end of withstand voltage tester 211 is connected with relay 216, and a second end of withstand voltage tester 211 is connected with any of industrial personal computers 3;
equipotential tester 212, configured to evaluate a potential difference between various parts of to-be-tested devices 7, wherein a first end of equipotential tester 212 is connected with relay 216, and a second end of equipotential tester 212 is connected with any of industrial personal computers 3;
multimeter 213, configured to detect an open-circuit voltage and/or short circuit of to-be-tested devices 7, wherein a first end of multimeter 213 is connected with relay 216, and a second end of multimeter 213 is connected with any of industrial personal computers 3;
communication module 214, configured to achieve data transmission with any of industrial personal computers 3, wherein a first end of communication module 214 is connected with relay 216, and a second end of communication module 214 is connected with any of industrial personal computers 3; and
first power supply 215, configured to provide power to equipment management units of to-be-tested devices 7 on the at least two testing stations in first testing workstation 11, wherein a first end of first power supply 215 is connected with relay 216, and a second end of first power supply 215 is connected with any of industrial personal computers 3.

In the embodiment of the present disclosure, relay 216 is an electronic switch that can open or close a circuit through electromagnetic force or electronic control. Withstand voltage tester 211 is configured to measure whether insulation of to-be-tested devices 7 or a route meets safety standards. Withstand voltage tester 211 tests whether the insulation of the equipment can prevent the flowing of the current by applying high voltage to ensure that the to-be-tested devices will not cause problems such as short circuit or electric leakage during normal running, thereby improving electrical safety. Withstand voltage tester 211 is configured to measure whether the insulation of to-be-tested devices 7 meets the safety standards. By applying the high voltage, withstand voltage tester 211 can determine whether the insulation of the equipment is strong enough to prevent current leakage or short circuit, thereby ensuring security and reliability of to-be-tested devices 7. Equipotential tester 212 is configured to evaluate a potential difference between various parts inside to-be-tested devices 7. Its main function is to measure a voltage or potential between different parts within the equipment and determine whether there is a potential difference between them and the magnitude of the difference. By measuring the potential difference between the different parts, potential electrical problems such as poor circuit connection, insulation faults, and electronic component damage can be detected. Multimeter 213 is configured to measure the open circuit voltage and/or detect short circuit conditions of to-be-tested devices 7, and is usually configured to measure the voltage, current, resistance and other electrical parameters of the circuit to ensure the normal running of the circuit and detect potential problems.

In the embodiment of the present disclosure, communication module 214 includes: first communication submodule 2141 and second communication submodule 2142. First communication submodule 2141 is hardware equipment of a controller area network flexible data rate (CANFD). Second communication submodule 2142 is hardware equipment of a USB controller area network (USBCAN). Specifically, the CANFD is an improved CAN protocol aimed to increase the speed and flexibility of data transmission on a CAN bus to meet application scenarios with higher bandwidth requirements. The USBCAN refers to a CAN bus adapter or interface equipment of a USB interface, which is used to connect a computer with the CAN bus.

In some embodiments of the present disclosure, as shown in Fig. 10, each testing workstation further includes: display equipment 8, connected with any of industrial personal computers 3, and configured to display a testing result of any of industrial personal computers 3 performing performance testing on to-be-tested devices 7.

In some embodiments of the present disclosure, as shown in Fig. 10, each testing workstation further comprises: verification equipment 9, connected with any of industrial personal computers 3, and configured to verify the product information of to-be-tested devices 7 on the at least two testing stations so as to obtain verification results, and transmit the verification results of to-be-tested devices 7 to any of industrial personal computers 3, wherein the verification results are used to indicate whether the product information of the to-be-tested devices is compliant.

In some embodiments of the present disclosure, the verification equipment 9 may be specialized hardware equipment or a software module integrated in any of industrial personal computers 3. Exemplarily, in a case that verification equipment 9 is hardware equipment, verification equipment 9 may be a manufacturing execution system (MES).

In the embodiment of the present disclosure, after verification equipment 9 acquires the product information of to-be-tested devices 7, verification equipment 9 verifies the product information of to-be-tested devices 7 according to a preset verification rule to obtain the verification results. The preset verification rules are used to detect whether the product information of to-be-tested devices 7 meets the expected standards.

In the embodiment of the present disclosure, the preset verification rules include at least one of the following: product information format verification, product information validity verification, product information consistency verification, product information range verification, repeatability verification, completeness verification, logical verification, historical data verification, security verification and communication verification.

In some embodiments of the present disclosure, as shown in Fig. 10, first testing workstation 11 further includes: an adapter box 611, configured to connect and manage terminal interfaces and connectors of to-be-tested devices 7 on the individual testing stations; and a first end of adapter box 611 is connected with relay 216, and a second end of adapter box 611 is connected with to-be-tested devices 7 on the at least two testing stations.

In the embodiment of the present disclosure, adapter box 611 is also called an EOL adapter box. Adapter box 611 helps ensure the quality of the produced products and provides the necessary interfaces and functions for final testing and data collection, thereby helping ensure products meet required quality standards before leaving the production line.

In some embodiments of the present disclosure, Fig. 11 is a schematic connection diagram of a testing instrument of an optional second testing workstation provided by an embodiment of the present disclosure. As shown in Fig. 11, second instrument cabinet 22 includes: charging and discharging equipment 221, configured to charge or discharge to-be-tested devices 7.

In some embodiments, as shown in Fig. 11, second testing workstation 12 further includes:
high-voltage adapter box 621, configured to connect a power supply to different loads, wherein a positive electrode of a first end of high-voltage adapter box 621 and a positive electrode of charging and discharging equipment 221, as well as a negative electrode of the first end of high-voltage adapter box 621 and a negative electrode of charging and discharging equipment 221 are respectively connected through a power voltage sampling line; a positive electrode of a second end of high-voltage adapter box 621 and a positive electrode of to-be-tested devices 7 on the at least two testing stations, as well as a negative electrode of the second end of high-voltage adapter box 621 and a negative electrode of to-be-tested devices 7 on the at least two testing stations are respectively connected through a power voltage sampling line; and
second power supply 622, configured to provide power to equipment management units (BMU) of to-be-tested devices 7 on the at least two testing stations in second testing workstation 12, and connected with to-be-tested devices 7 on the at least two testing stations.

In the embodiment of the present disclosure, high-voltage adapter box 621 is configured to connect a high-voltage power supply to different loads or testing objects. Its main function is to provide safe high-voltage power supply connection and distribute the power supply to different testing points, circuits or loads as needed.

In the embodiment of the present disclosure, for each testing station in first testing workstation 11, first bracket 61 is provided for fixing and supporting adapter box 611. Fig. 12 is a schematic structural diagram of an optional first bracket provided by an embodiment of the present disclosure. As shown in Fig. 12, adapter box 611 is fixedly connected to first bracket 61, and first bracket 61 may provide supporting for adapter box 611.

In the embodiment of the present disclosure, for each testing station in second testing workstation 12, a second bracket 62 is provided for fixing and supporting high-voltage adapter box 621 and second power supply 622. Fig. 13 is a schematic structural diagram of an optional second bracket provided by an embodiment of the present disclosure. As shown in Fig. 13, high-voltage adapter box 621 and second power supply 622 are fixedly connected to second bracket 62, and second bracket 62 may provide supporting for high-voltage adapter box 621 and second power supply 622.

In some embodiments of the present disclosure, any of the industrial personal computers is further configured to control the to-be-tested devices on the at least two testing stations to perform corresponding performance testing according to overall testing procedures respectively corresponding to the at least two testing stations, wherein the overall testing procedure of the to-be-tested device is related to the product information of the to-be-tested devices.

In the embodiment of the present disclosure, first, the overall testing procedure for performance testing corresponding to the to-be-tested devices on the at least two testing stations is determined through any of the industrial personal computers, and then the to-be-tested devices on the at least two testing stations is controlled to perform the corresponding performance testing according to the overall testing procedures respectively corresponding to the at least two testing stations.

It may be understood that the to-be-tested devices on the at least two testing stations are simultaneously controlled to perform performance testing through any of the industrial personal computers, and the overall testing procedures corresponding to the at least two testing stations may be different. In this way, different testing tasks are performed according to different to-be-tested devices and testing requirements, which can help to improve production efficiency and diversity while ensuring testing accuracy and consistency.

In some embodiments of the present disclosure, the product information varies among the to-be-tested devices on the at least two testing stations; and the product information includes at least one of the following: model information, project information or blueprint information of the to-be-tested devices.

In some embodiments of the present disclosure, an identification label is affixed to the to-be-tested devices; and each testing workstation further includes: recognition equipment, arranged on the at least two testing stations, connected with any of the industrial personal computers, and configured to read the identification label of the to-be-tested device on any of the at least two testing stations, acquire the product information of the to-be-tested devices, and transmit the product information of the to-be-tested devices to any of the industrial personal computers corresponding to any testing station; and
any of the industrial personal computers is further configured to determine the overall testing procedure of the to-be-tested devices on the at least two testing stations according to the product information of the to-be-tested devices on the at least two testing stations.

In the embodiment of the present disclosure, the identification label is a small label or sticker that carries the product information of the to-be-tested devices. The identification label may be represented in a mode of a serial number, a batch number, a barcode label, a quick response code (QR) label, a radio-frequency identification (RFID) label, etc.

In the embodiment of the present disclosure, the recognition equipment may be arranged on each testing station to facilitate recognition of the identification label on the to-be-tested device on the testing station, thereby acquiring the product information of the to-be-tested devices.

It can be understood that in the embodiments of the present disclosure, on the one hand, the automatic recognition equipment reads the identification label and automatically transmits the product information without the need to manually record and enter data, thereby reducing manual operations and potential errors, and improving the efficiency of the production line. On the other hand, automatic label reading and information transmission reduce the risk of data entry errors and ensure the accuracy of the product information.

In some embodiments of the present disclosure, the at least two testing stations controlled by any of the industrial personal computers are respectively deployed on at least two transmission channels, and the at least two transmission channels are independent of each other.

It may be understood that in the embodiment of the present disclosure, the at least two testing stations are respectively deployed on the at least two independent transmission channels. On the one hand, different transmission channels may be configured to test different products or perform different quality control steps, thereby helping ensure the product quality. On the one hand, parallel processing of different products or procedures can increase the production line's capacity to meet more customer needs. On the one hand, if a procedure on a certain transmission channel takes more time, it will not affect the production process on other channels, reducing congestion on the production line. In addition, if the equipment or system of one transmission channel fails, other channels can continue to operate, ensuring that production is not greatly affected.

In some embodiments of the present disclosure, the at least one testing workstation is further configured to perform at least one performance testing on the to-be-tested devices at each testing station flowing through any transmission channel.

It may be understood that on the one hand, any of the industrial personal computers can simultaneously control the performance testing of the plurality of testing stations, reduce a waiting time of the testing procedure and improve the overall efficiency of the production line. On the other hand, the individual testing stations on any transmission channel can sequentially perform testing, thereby shortening the time of the entire testing process and improving the overall efficiency of the production line.

In some embodiments of the present disclosure, any of the industrial personal computers is further configured to split an overall testing procedure corresponding to any transmission channel, such that testing times of target testing procedures at the individual testing stations of the to-be-tested devices located on any transmission channel are close, wherein
the target testing procedure belongs to a partial testing procedure in the overall testing procedure; and the overall testing procedure corresponding to any transmission channel is a sum of the target testing procedures corresponding to the individual testing stations on any transmission channel.

It may be understood that on the one hand, by splitting the overall testing procedure according to the number of the testing stations on any transmission channel, performance testing of the plurality of testing stations can be performed in parallel, thereby greatly improving the testing efficiency and reducing the testing time. On the other hand, any testing station on any transmission channel does not need to wait for other testing stations to complete the testing, thereby reducing an idle time of the testing equipment and increasing resource utilization.

In the embodiment of the present disclosure, testing system further includes: transportation equipment, configured to transport the to-be-tested devices to any of the at least two testing stations.

In the embodiment of the present disclosure, the transportation equipment transports the to-be-tested devices to any of the at least two testing stations corresponding to any of the industrial personal computers in any testing workstation in response to a received transportation instruction. The transportation instruction is used to indicate positioning information or guidance information of any testing station corresponding to the to-be-tested devices.

In the embodiment of the present disclosure, the transportation equipment may be an automated guided vehicle (AGV), a mechanical arm, a conveyor belt, etc.

In some embodiments of the present disclosure, the testing system further includes: a data transmission module, connected with any of the industrial personal computers and the at least one testing instrument, and configured to achieve data transmission and network connection.

For example, the data transmission module may be a switch.

In the embodiment of the present disclosure, the testing system enables two industrial personal computers to control four testing stations, one EOL industrial personal computer to control two EOL testing stations, and each testing station to run independently, achieving compatibility with one production line and four types of PACKs (to-be-tested devices) simultaneously. During normal production, four PACKs of the same product can be tested simultaneously, greatly improving the production line takt.

In the embodiment of the present disclosure, only two industrial personal computers and four testing stations can realize the simultaneous production of multiple items in the production line. Through the optimization program, one industrial personal computer can control two independent testing stations simultaneously. By designing two industrial personal computers with different electrical performance testing in a single workstation, the single station is compatible with both EOL and DCR testing simultaneously. Each industrial personal computer can control two stations through an optimization program. The two stations can test different product items simultaneously to achieve non-stop changeover, namely one-click changeover.

In the embodiment of the present disclosure, one-click changeover of all stations is realized through program and industrial personal computer control, and two projects can be produced online at the same time.

**In** the embodiment of the present disclosure, different blueprint projects can be compatible with performance testing at the same time, such as product end-of-line performance testing (EOL testing).

**In** the embodiment of the present disclosure, by optimizing the program of the industrial personal computers, four battery packs (to-be-tested devices) of the same product can be tested simultaneously with only two industrial personal computers.

**In** the embodiment of the present disclosure, multiple blueprints and multiple projects can be compatible for EOL testing at the same time.

**In** the embodiment of the present disclosure, one-click changeover and non-stop changeover can be realized to increase the production line utilization.

It should be understood that references throughout the specification to "one embodiment" or "an embodiment" imply that specific features, structures, or characteristics related to the embodiment are included in at least one embodiment of the present disclosure. Thus, "in one embodiment" or "in an embodiment" that appears throughout the specification may not necessarily refer to the same embodiment. In addition, these specific features, structures, or characteristics may be combined in one or more embodiments in any suitable manner. It should be understood that in the various embodiments of the present disclosure, the size of the serial numbers of the above steps/processes does not imply the order of execution, and the execution order of each step/process should be determined by its function and internal logic, and should not constitute any limitations on the implementation process of the embodiment of the present disclosure. The above serial numbers of the embodiment of the present disclosure are only for description and do not represent the advantages and disadvantages of the embodiments.

The orientation or positional relationships indicated by the terms "upper", "lower", "top", "bottom", "front", "rear", "inner", "outer" and the like are used in the present disclosure only for facilitating the description of the present disclosure, rather than indicating or implying that the device referred to must have a particular orientation or be constructed and operated in a particular orientation, and therefore shall not be interpreted as limiting the protection scope of the present disclosure.

In the description of the present disclosure, it should also be noted that, unless otherwise expressly specified and limited, the terms "mount", "connected", and "connecting" should be broadly understood, for example, they may be a fixed connection or a detachable connection or be an integrated connection; or may be a direct connection or an indirect connection through an intermediate medium. Those skilled in the art may understand the specific meaning of the above terms in the present disclosure according to the specific situation.

It should be noted that terms "including", "containing", or any other variations in the present disclosure are intended to cover non-exclusive inclusion, such that a process, method, item or apparatus that includes a series of elements not only includes those elements, but also other elements that are not explicitly listed, or further include elements inherent in such the process, method, item or apparatus. Without more limitations, elements defined by a statement "including one" do not exclude the existence of other identical elements in the process, method, item or apparatus that includes the said elements.

In several embodiments provided in the present disclosure, it should be understood that the disclosed system, equipment and method may be implemented in other ways. The equipment embodiments described above are only illustrative. for example, dividing of units is only a kind of logical function dividing, and there may be other dividing modes in actual implementation. For example, the plurality of units or components can be combined or integrated into another system, or some features can be ignored or not executed. In addition, the coupling, direct coupling, or communication connection between the various components displayed or discussed can be indirect coupling or communication connection through some interfaces, equipment or units, which can be electrical, mechanical, or other forms.

The units mentioned above as separate components may be, or may not be physically separated, and the parts displayed as units may be, or may not be physical units; they may be located in one place or distributed onto a plurality of network units; and some or all of the units can be selected according to actual needs to achieve the purpose of the solution of this embodiment. In addition, all functional units in the embodiments of the present disclosure may be integrated into one processing unit, or each unit may serve as a separate unit, or two or more units may be integrated into one unit. The integrated units mentioned above may be implemented in a hardware form or in a form of hardware and software functional units.

The above is only an implementation of the present disclosure, but the scope of protection of the present disclosure is not limited to this. Any changes or replacements that can be easily thought of by technical personnel familiar with the technical field within the technical scope disclosed in the present disclosure needs to be covered within the scope of protection of the present disclosure.

### Industrial Applicability

The embodiments of the present disclosure provide a testing method and a testing system, which can improve the testing efficiency, thereby improving the production takt of the production line, and further increasing the production capacity.

## Claims

1. A testing method, applied to a testing system, the testing system comprising: at least one testing workstation and transportation equipment, wherein each testing workstation comprises: at least one testing instrument, at least one industrial personal computer, and at least two testing stations corresponding to each industrial personal computer, the testing method comprises:
transporting, by the transportation equipment, to-be-tested devices to the at least two testing stations corresponding to any industrial personal computer in any testing workstation; and
in a case that said any industrial personal computer and the at least one testing instrument are in a state connected with each other and the at least one testing instrument and the at least two testing stations are in a state connected with each other, controlling, by said any industrial personal computer, the to-be-tested devices on the at least two testing stations to each undergo corresponding performance testing, wherein the at least two testing stations are independent of each other.

2. The testing method according to claim 1, wherein the controlling, by said any industrial personal computer, the to-be-tested devices on the at least two testing stations to each undergo corresponding performance testing comprises:
determining, by said any industrial personal computer, overall testing procedures for performance testing respectively corresponding to the to-be-tested devices on the at least two testing stations, wherein the overall testing procedures for performance testing respectively corresponding to the at least two testing stations are different; and
controlling the to-be-tested devices on the at least two testing stations to undergo corresponding performance testing according to the overall testing procedures respectively corresponding to the at least two testing stations.

3. The testing method according to claim 2, wherein the determining, by said any industrial personal computer, the overall testing procedures for performance testing respectively corresponding to the to-be-tested devices on the at least two testing stations comprises:
acquiring product information of the to-be-tested devices on the at least two testing stations by said any industrial personal computer; and
determining the overall testing procedures of the to-be-tested devices on the at least two testing stations according to the product information of the to-be-tested devices on the at least two testing stations.

4. The testing method according to claim 3, wherein the product information varies among the to-be-tested devices on the at least two testing stations, and the product information comprises at least one of the following: model information, project information, and blueprint information of the to-be-tested devices.

5. The testing method according to claim 3, wherein an identification label is affixed to each of the to-be-tested devices, and each testing station further comprises: recognition equipment configured to recognize the identification label on each of the to-be-tested devices; and
the acquiring the product information of the to-be-tested devices on the at least two testing stations by said any industrial personal computer comprises:
reading, in a case that any of the to-be-tested devices arrives at any of the at least two testing stations, the identification label of said to-be-tested device on said any testing station by recognition equipment corresponding to said any testing station; and
parsing the identification label of said to-be-tested device by the recognition equipment so as to acquire product information of said to-be-tested device, and transmitting the product information of said to-be-tested device to said any industrial personal computer corresponding to said any testing station, such that said any industrial personal computer acquires the product information of the to-be-tested devices on the at least two testing stations.

6. The testing method according to any one of claims 1 to 5, wherein each testing workstation further comprises: verification equipment configured to verify the product information of the to-be-tested devices, and the testing method further comprises:
transmitting the product information of the to-be-tested devices on the at least two testing stations to the verification equipment by said any industrial personal computer; and
verifying the product information of the to-be-tested devices on the at least two testing stations by the verification equipment so as to obtain verification results, wherein the verification results are used for indicating whether the product information of the to-be-tested devices is compliant.

7. The testing method according to claim 6, wherein after verifying the product information of the to-be-tested devices on the at least two testing stations by the verification equipment so as to obtain the verification results, the testing method further comprises:
feeding, by the verification equipment, the verification results of to-be-tested devices on the at least two testing stations back to said any industrial personal computer; and
executing, in a case that the verification results indicate that the product information of the to-be-tested devices on the at least two testing stations is compliant, the step of controlling, by said any industrial personal computer, the to-be-tested devices on the at least two testing stations to each undergo corresponding performance testing.

8. The testing method according to claim 2, wherein the at least two testing stations controlled by said any industrial personal computer are respectively deployed on at least two transmission channels, and the at least two transmission channels are independent of each other; and
the controlling the to-be-tested devices on the at least two testing stations to each undergo corresponding performance testing according to the overall testing procedures respectively corresponding to the at least two testing stations comprises:
controlling, by said any industrial personal computer, to-be-tested devices located on respective testing stations of the at least two transmission channels to simultaneously undergo performance testing under respective overall testing procedures; or, controlling, by said any industrial personal computer, to-be-tested devices located on respective testing stations of any of the transmission channels to each undergo performance testing under a respective target testing procedure in sequence, wherein
the target testing procedure is a partial testing procedure in an overall testing procedure; and an overall testing procedure corresponding to said any transmission channel is a sum of target testing procedures corresponding to respective testing stations on said any transmission channel.

9. The testing method according to claim 8, wherein the controlling, by said any industrial personal computer, the to-be-tested devices located on respective testing stations of any of the transmission channels to each undergo performance testing under a respective target testing procedure in sequence comprises:
splitting, by said any industrial personal computer, the overall testing procedure corresponding to said any transmission channel according to the number of testing stations located on said any transmission channel, so as to determine a target testing procedure of a testing station located on said any transmission channel and corresponding to said any industrial personal computer; and
controlling, by said any industrial personal computer, a to-be-tested device on said testing station located on said any transmission channel and corresponding to said any industrial personal computer to undergo performance testing under the target testing procedure corresponding to said testing station, wherein
for a to-be-tested device located on said any transmission channel, a difference in testing time under target testing procedures at respective testing stations is less than or equal to a preset threshold.

10. The testing method according to claim 9, wherein said any testing workstation is a first testing workstation configured to perform product end-of-line performance testing on the to-be-tested devices; the at least two transmission channels comprise: a first transmission channel and a second transmission channel; said any industrial personal computer is a first industrial personal computer; and the at least two testing stations corresponding to the first industrial personal computer comprise: a first testing station located on the first transmission channel and a second testing station located on the second transmission channel; and
the controlling, by said any industrial personal computer, a to-be-tested device on said testing station located on said any transmission channel and corresponding to said any industrial personal computer to undergo performance testing under the target testing procedure corresponding to said testing station comprises:
transporting a first to-be-tested device to the first testing station by the transportation equipment; and controlling, by the first industrial personal computer in a case that the first industrial personal computer detects that the first to-be-tested device arrives at the first testing station, the first to-be-tested device to undergo product end-of-line performance testing of a first target testing procedure corresponding to the first testing station; and/or,
transporting a second to-be-tested device to the second testing station by the transportation equipment; and controlling, by the first industrial personal computer in a case that the first industrial personal computer detects that the second to-be-tested device arrives at the second testing station, the second to-be-tested device to undergo product end-of-line performance testing of a second target testing procedure corresponding to the second testing station, wherein
the first target testing procedure is a partial testing procedure in a first overall testing procedure corresponding to the first transmission channel, and the second target testing procedure is a partial testing procedure in a second overall testing procedure corresponding to the second transmission channel; and the first overall testing procedure is related to product information of the first to-be-tested device, and the second overall testing procedure is related to product information of the second to-be-tested device.

11. The testing method according to claim 10, wherein the first testing workstation further comprises: a second industrial personal computer; and the testing method further comprises: controlling, by the second industrial personal computer after the first to-be-tested device and/or the second to-be-tested device each completes the product end-of-line performance testing under the respective target testing procedure corresponding to the first industrial personal computer, the first to-be-tested device and/or the second to-be-tested device to each undergo product end-of-line performance testing under a testing procedure other than the target testing procedures corresponding to the first industrial personal computer.

12. The testing method according to claim 11, wherein the at least two testing stations corresponding to the second industrial personal computer comprise: a third testing station located on the first transmission channel and a fourth testing station located on the second transmission channel, the third testing station is deployed downstream of the first testing station, and the fourth testing station is deployed downstream of the second testing station; and
the controlling, by the second industrial personal computer, the first to-be-tested device and/or the second to-be-tested device to each undergo product end-of-line performance testing under a testing procedure other than the target testing procedures corresponding to the first industrial personal computer comprises:
controlling, by the second industrial personal computer in a case that the second industrial personal computer detects that the first to-be-tested device arrives at the third testing station, the first to-be-tested device to undergo product end-of-line performance testing under a third target testing procedure corresponding to the third testing station; and/or,
controlling, by the second industrial personal computer in a case that the second industrial personal computer detects that the second to-be-tested device arrives at the fourth testing station, the second to-be-tested device to undergo product end-of-line performance testing under a fourth target testing procedure corresponding to the fourth testing station, wherein a sum of the first target testing procedure and the third target testing procedure is the first overall testing procedure; and a sum of the second target testing procedure and the fourth target testing procedure is the second overall testing procedure.

13. The testing method according to claim 12, wherein the at least one testing workstation further comprises: a second testing workstation configured to perform direct current resistance performance testing on the to-be-tested devices; the second testing workstation is a testing workstation located downstream of the first testing workstation; the second testing workstation comprises: a third industrial personal computer; and the testing method further comprises:
controlling, by the third industrial personal computer after the first to-be-tested device and/or the second to-be-tested device each completes the product end-of-line performance testing corresponding to the first testing workstation, the first to-be-tested device and/or the second to-be-tested device to undergo direct current resistance performance testing.

14. The testing method according to claim 13, wherein the at least two testing stations corresponding to the third industrial personal computer comprise: a fifth testing station located on the first transmission channel and a sixth testing station located on the second transmission channel, the fifth testing station is deployed downstream of the third testing station, and the sixth testing station is deployed downstream of the fourth testing station; and the controlling, by the third industrial personal computer, the first to-be-tested device and/or the second to-be-tested device to undergo direct current resistance performance testing comprises:
controlling, by the third industrial personal computer in a case that the third industrial personal computer detects that the first to-be-tested device arrives at the fifth testing station, the first to-be-tested device to undergo direct current resistance performance testing under a third overall testing procedure corresponding to the fifth testing station; and/or,
controlling, by the third industrial personal computer in a case that the third industrial personal computer detects that the second to-be-tested device arrives at the sixth testing station, the second to-be-tested device to undergo direct current resistance performance testing under a fourth overall testing procedure corresponding to the sixth testing station, wherein the third overall testing procedure is related to the product information of the first to-be-tested device, and the fourth overall testing procedure is related to the product information of the second to-be-tested device.

15. The testing method according to claim 10, wherein the at least one testing workstation further comprises: a third testing workstation configured to perform air tightness performance testing on the to-be-tested devices; and the third testing workstation is a testing workstation located upstream of the first testing workstation; and
before the controlling, by said any industrial personal computer, the to-be-tested devices on the at least two testing stations to undergo the product end-of-line performance testing, the testing method further comprises: controlling, by an industrial personal computer in the third testing workstation, the to-be-tested devices on the at least two testing stations to undergo air tightness performance testing.

16. A testing system, comprising: at least one testing workstation configured to perform at least one performance testing on to-be-tested devices, wherein each testing workstation comprises: at least one testing instrument, at least one industrial personal computer, and at least two testing stations corresponding to each industrial personal computer; any industrial personal computer is connected with the at least one testing instrument; and the at least one testing instrument is connected with the at least two testing stations; and
said any industrial personal computer is configured to control the to-be-tested devices on the at least two testing stations to each undergo corresponding performance testing based on the at least one testing instrument, wherein the at least two testing stations are independent of each other.

17. The testing system according to claim 16, wherein said any industrial personal computer is further configured to control the to-be-tested devices on the at least two testing stations to undergo corresponding performance testing according to overall testing procedures respectively corresponding to the at least two testing stations, wherein
the overall testing procedures for the to-be-tested devices are related to product information of the to-be-tested devices; and the overall testing procedures for performance testing corresponding to the at least two testing stations are different.

18. The testing system according to claim 17, wherein the product information varies among the to-be-tested devices on the at least two testing stations, and the product information comprises at least one of the following: model information, project information, or blueprint information of the to-be-tested device.

19. The testing system according to claim 17, wherein an identification label is affixed to each of the to-be-tested devices; and each testing workstation further comprises: recognition equipment, arranged on the at least two testing stations, connected with said any industrial personal computer, and configured to read the identification label of a to-be-tested device on any of the at least two testing stations, acquire the product information of said to-be-tested device, and transmit the product information of said to-be-tested device to said any industrial personal computer corresponding to said any testing station; and
said any industrial personal computer is further configured to determine the overall testing procedures for the to-be-tested devices on the at least two testing stations according to the product information of the to-be-tested devices on the at least two testing stations.

20. The testing system according to claim 16, wherein each testing workstation further comprises: verification equipment, connected with said any industrial personal computer, and configured to verify the product information of the to-be-tested devices on the at least two testing stations so as to obtain verification results, and transmit the verification results of the to-be-tested devices to said any industrial personal computer, wherein
the verification results are used to indicate whether the product information of the to-be-tested devices is compliant.

21. The testing system according to claim 16, wherein the at least two testing stations controlled by said any industrial personal computer are respectively deployed on at least two transmission channels, and the at least two transmission channels are independent of each other.

22. The testing system according to claim 21, wherein the at least one testing workstation is further configured to perform at least one performance testing on the to-be-tested devices flowing through each testing station on any of the transmission channels.

23. The testing system according to claim 22, wherein said any industrial personal computer is further configured to split an overall testing procedure corresponding to said any transmission channel, such that for a to-be-tested device located on said any transmission channel, a difference in testing time under target testing procedures at respective testing stations is less than or equal to a preset threshold, wherein
the target testing procedures are each a partial testing procedure in the overall testing procedure; and the overall testing procedure corresponding to said any transmission channel is a sum of the target testing procedures corresponding to the respective testing stations on said any transmission channel.

24. The testing system according to any of claims 16 to 23, wherein the at least one testing workstation comprises: a first testing workstation and a second testing workstation, and the second testing workstation is a testing workstation located downstream of the first testing workstation;
the first testing workstation is configured to perform product end-of-line performance testing on the to-be-tested devices; and
the second testing workstation is configured to perform direct current resistance performance testing on the to-be-tested devices.

25. The testing system according to claim 24, wherein the first testing workstation comprises: a first industrial personal computer, a second industrial personal computer, a first testing station, a second testing station, a third testing station and a fourth testing station; the at least two transmission channels comprise: a first transmission channel and a second transmission channel; the third testing station is deployed downstream of the first testing station, and the fourth testing station is deployed downstream of the second testing station; the first testing station and the third testing station are deployed on the first transmission channel; and the second testing station and the fourth testing station are deployed on the second transmission channel;
the first industrial personal computer is configured to control a first to-be-tested device to undergo product end-of-line performance testing under a first target testing procedure corresponding to the first testing station, and control a second to-be-tested device to undergo product end-of-line performance testing under a second target testing procedure corresponding to the second testing station; and
the second industrial personal computer is configured to control the first to-be-tested device to undergo product end-of-line performance testing under a third target testing procedure corresponding to the third testing station and control the second to-be-tested device to undergo product end-of-line performance testing under a fourth target testing procedure corresponding to the fourth testing station, wherein a sum of the first target testing procedure and the third target testing procedure is a first overall testing procedure corresponding to the first transmission channel; a sum of the second target testing procedure and the fourth target testing procedure is a second overall testing procedure corresponding to the second transmission channel; and the first overall testing procedure is related to product information of the first to-be-tested device, and the second overall testing procedure is related to product information of the second to-be-tested device.

26. The testing system according to claim 25, wherein the second testing workstation comprises: a third industrial personal computer, a fifth testing station and a sixth testing station; the second testing workstation is a testing workstation located downstream of the first testing workstation; the fifth testing station is deployed downstream of the third testing station, and the sixth testing station is deployed downstream of the fourth testing station; the fifth testing station is deployed on the first transmission channel; and the sixth testing station is deployed on the second transmission channel; and
the third industrial personal computer is configured to control the first to-be-tested device to undergo direct current resistance performance testing under a third overall testing procedure corresponding to the fifth testing station and control the second to-be-tested device to undergo direct current resistance performance testing under a fourth overall testing procedure corresponding to the sixth testing station, wherein the third overall testing procedure is related to the product information of the first to-be-tested device, and the fourth overall testing procedure is related to the product information of the second to-be-tested device.

27. The testing system according to claim 24, wherein the at least one testing workstation further comprises: a third testing workstation configured to perform air tightness testing on the to-be-tested devices; and the third testing workstation is a testing workstation located upstream of the first testing workstation.

28. The testing system according to any one of claims 16 to 23, further comprises: an instrument cabinet, wherein
the at least one testing instrument in the at least one testing workstation is integrated in the instrument cabinet and configured to perform corresponding performance testing on the to-be-tested devices.

29. The testing system according to claim 28, wherein the instrument cabinet comprises a first instrument cabinet and a second instrument cabinet;
the first instrument cabinet is located in the first testing workstation, the at least one testing instrument in the first testing workstation is integrated in the first instrument cabinet, and instruments in the first instrument cabinet are configured to perform product end-of-line performance testing on to-be-tested devices on the at least two testing stations in the first testing workstation; and
the second instrument cabinet is located in the second testing workstation, the at least one testing instrument in the second testing workstation is integrated in the second instrument cabinet, and instruments in the second instrument cabinet are configured to perform direct current resistance performance testing on the to-be-tested devices on the at least two testing stations in the second testing workstation.

30. The testing system according to claim 29, wherein the first instrument cabinet comprises:
a relay configured to control flowing of a current in a circuit according to a voltage level;
a withstand voltage tester configured to test insulation of the to-be-tested device, wherein a first end of the withstand voltage tester is connected with the relay, and a second end of the withstand voltage tester is connected with said any industrial personal computer;
an equipotential tester configured to evaluate a potential difference between various parts of the to-be-tested devices, wherein a first end of the equipotential tester is connected with the relay, and a second end of the equipotential tester is connected with said any industrial personal computer;
a multimeter configured to detect an open-circuit voltage and/or short circuit of the to-be-tested devices, wherein a first end of the multimeter is connected with the relay, and a second end of the multimeter is connected with said any industrial personal computer;
a communication module configured to achieve data transmission with said any industrial personal computer, wherein a first end of the communication module is connected with the relay, and a second end of the communication module is connected with said any industrial personal computer; and
a first power supply configured to provide power to a device management unit for the to-be-tested devices on the at least two testing stations in the first testing workstation, wherein a first end of the first power supply is connected with the relay, and a second end of the first power supply is connected with said any industrial personal computer.

31. The testing system according to claim 30, wherein the first testing workstation further comprises: an adapter box configured to connect and manage terminal interfaces and connectors of the to-be-tested devices on the testing stations; and a first end of the adapter box is connected with the relay, and a second end of the adapter box is connected with the to-be-tested devices on the at least two testing stations.

32. The testing system according to claim 29, wherein the second instrument cabinet comprises:
charging and discharging equipment configured to charge or discharge the to-be-tested devices.

33. The testing system according to claim 32, wherein the second testing workstation further comprises:
a high-voltage adapter box configured to connect a power supply to different loads, wherein a positive electrode of a first end of the high-voltage adapter box and a positive electrode of the charging and discharging equipment are connected to each other through a power voltage sampling line, and a negative electrode of the first end of the high-voltage adapter box and a negative electrode of the charging and discharging equipment are connected to each other through a power voltage sampling line; a positive electrode of a second end of the high-voltage adapter box and a positive electrode of each of the to-be-tested devices on the at least two testing stations are connected to each other through a power voltage sampling line, and a negative electrode of the second end of the high-voltage adapter box and a negative electrode of each of the to-be-tested device on the at least two testing stations are connected to each other through a power voltage sampling line; and
a second power supply configured to provide power to a device management unit for the to-be-tested devices on the at least two testing stations in the second testing workstation, and connected with the to-be-tested devices on the at least two testing stations.

34. The testing system according to any one of claims 16 to 23, wherein each testing workstation further comprises: display equipment connected with said any industrial personal computer, and configured to display a testing result of performance testing on the to-be-tested devices performed by said any industrial personal computer.

35. The testing system according to any one of claims 16 to 23, further comprises: transportation equipment configured to transport a to-be-tested device to any of the at least two testing stations.

36. The testing system according to any one of claims 16 to 23, further comprises: a data transmission module connected with said any industrial personal computer and the at least one testing instrument, and configured to achieve data transmission and network connection.

37. The testing system according to any one of claims 16 to 23, further comprises: a material cabinet configured to house wire harness fixtures.
